(19) Europäisches Patentamt
European Patent Office
Office européen des brevets

(11) **EP 1 542 058 B1**

(12) **EUROPEAN PATENT SPECIFICATION**

(45) Date of publication and mention
of the grant of the patent:
**28.02.2007 Bulletin 2007/09**

(51) Int Cl.:
***G02B 26/08*** (2006.01)

(21) Application number: **04292909.1**

(22) Date of filing: **08.12.2004**

(54) **Diffraction grating-optical modulation apparatus with an improved heat stability**

Optische Modulationsvorrichtung mit Beugungsgitter, die eine verbesserte Wärmestabilität aufweist

Dispositif de modulation optique basé sur un réseau de diffraction ayant une stabilité thermique améliorée

(84) Designated Contracting States:
**DE FR GB**

(30) Priority: **08.12.2003 JP 2003408581**
**22.09.2004 JP 2004274362**

(43) Date of publication of application:
**15.06.2005 Bulletin 2005/24**

(73) Proprietor: **SONY CORPORATION**
**Tokyo (JP)**

(72) Inventors:
• **Oniki, Kazunao,c/o Sony Corporation**
**Tokyo (JP)**
• **Tamada, Hitoshi,c/o Sony Corporation**
**Tokyo (JP)**

(74) Representative: **Thévenet, Jean-Bruno et al**
**Cabinet Beau de Loménie**
**158, rue de l'Université**
**75340 Paris Cédex 07 (FR)**

(56) References cited:
**EP-A- 0 604 335**    **EP-A- 1 243 971**
**US-A1- 2003 035 195**    **US-A1- 2003 142 928**
**US-B1- 6 273 620**    **US-B1- 6 339 605**

• **PATENT ABSTRACTS OF JAPAN vol. 008, no. 105 (P-274), 17 May 1984 (1984-05-17) & JP 59 015206 A (CANON KK), 26 January 1984 (1984-01-26)**
• **PATENT ABSTRACTS OF JAPAN vol. 003, no. 159 (E-162), 27 December 1979 (1979-12-27) & JP 54 139423 A (CANON INC), 29 October 1979 (1979-10-29)**

**Description**

BACKGROUND OF THE INVENTION

The present invention relates to an optical apparatus and an image production apparatus.

Document US 2003/0142928 describes an opto-electronic integrated circuit for reducing the heat generated at a driver circuit for an optical modulator.

Document US 6 273 620 describes a fibre grating laser module comprising a semiconductor optical amplifier and a grating fibre being cooled by a Peltier element.

Document EP 0 604 335 discloses an optical assembly comprising a laser beam source mounted on a metallic mount cooled by a thermoelectric module and a heat sink.

Document JP 59 015 206 describes a laser unit comprising a laser source, a heat sink, a support assembly and a collimating lens, wherein said support assembly is thermally expanded according to temperature variations.

Document EP 1 243 971 describes an exposure device comprising a GLV (Grating Light Valve) element used as a light modulator array in an exposure head for reading data.

Document JP 54 139 423 describes a pickup device wherein a copper heat sink is adhered to a charge coupling element and to a cooling element.

Document US 2003/0035195 describes a grating light valves device having a plurality ribbon structure covered by a thin reflective layer, wherein degradation of the thin reflective layer is reduced.

Document US 6 339 605 describes an active mirror amplifier laser module with a substrate having a plurality of microchannels through which a coolant is circulated.

An image forming apparatus such as a projector and a printer (refer to, for example, Japanese Patent Laid-Open No. 2003-140354, hereinafter referred to as Patent Document 1) wherein a flux of light from a one-dimensional image production apparatus is scanned by an optical scanning block and projected to an image forming block to form a two-dimensional image is disclosed in and known from, for example, Japanese Patent No. 3,401,250 (hereinafter referred to as Patent Document 2) and Japanese Patent No. 3,164,825 (hereinafter referred to as Patent Document 3). The one-dimensional image production apparatus disclosed in Patent Document 2 and Patent Document 3 includes an optical element wherein a plurality of diffraction grating-optical modulation elements (GLV: Grating Light Valve) are arranged in a one-dimensional array. In the following description, such an optical element as just mentioned is sometimes referred to as diffraction grating-optical modulation apparatus. Usually, the diffraction grating-optical modulation apparatus (optical element) further includes a light transmitting member made of a glass plate and opposed to a plurality of diffraction grating-optical modulation elements for transmitting incoming light incoming into the diffraction grating-optical modulation apparatus and outgoing light outgoing from the diffraction grating-optical modulation apparatus therethrough. The diffraction grating-optical modulation elements are produced applying a micromachine production technique and are formed from diffraction gratings of the reflection type. The diffraction grating-optical modulation elements have a light switching action and display an image by electrically controlling on/off (transmission/interception) of light. In particular, light emitted from the diffraction grating-optical modulation elements of the diffraction grating-optical modulation apparatus is scanned by a scanning mirror to obtain a two-dimensional image. Accordingly, to display a two-dimensional image formed from M × N (for example, 1,920 × 1,080) pixels, the diffraction grating-optical modulation apparatus should be formed from N (= 1,080) diffraction grating-optical modulation elements. Further, for color display, three image production apparatus each including such a diffraction grating-optical modulation apparatus as just described should be used.

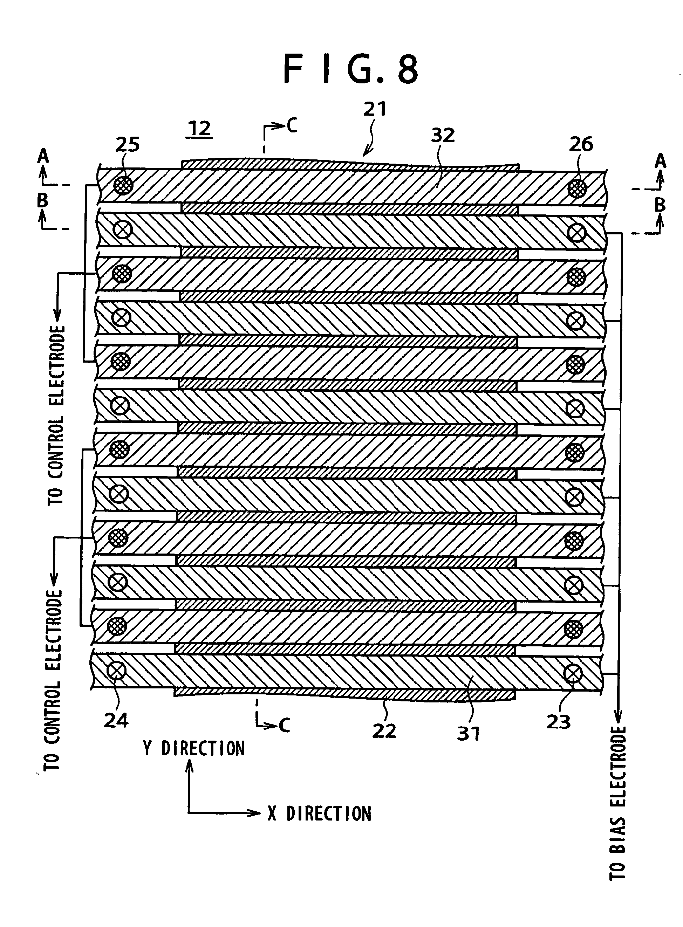

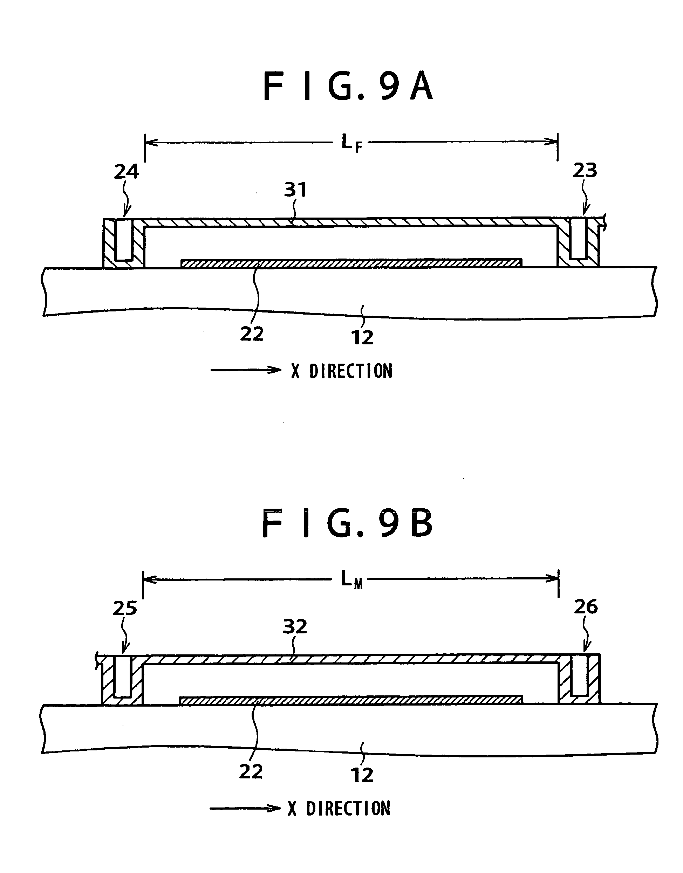

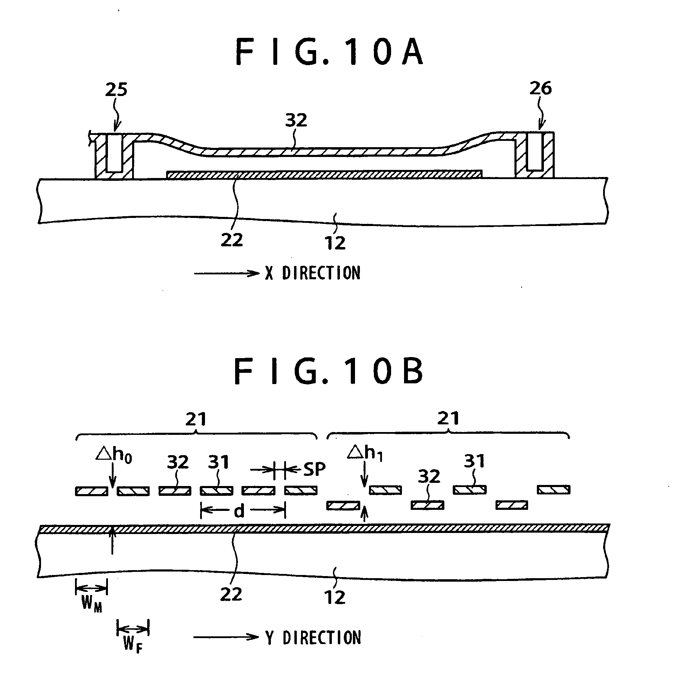

FIG. 8 schematically shows a diffraction grating-optical modulation apparatus including diffraction grating-optical modulation elements and particularly shows arrangement of lower electrode 22, fixed electrodes 31, movable electrodes 32 and so forth of the diffraction grating-optical modulation elements 21. FIG. 9A is a schematic partial sectional view taken along line B-B of FIG. 8 showing a fixed electrode 31 and so forth, and FIGS. 9B and 10A are schematic partial sectional views taken along line A-A of FIG. 8 showing a movable electrode 32 and so forth. Further, FIG. 10B is a schematic partial sectional view taken along line C-C of FIG. 8 showing a fixed electrode 31, a movable electrode 32 and so forth. Here, the movable electrode 32 before it is displaced is shown in FIG. 9B and on the left side in FIG. 10B, and the movable electrode 32 after it is displaced is shown in FIG. 10A and on the right side in FIG. 10B. Further, in FIG. 8, slanting lines are applied to the lower electrode 22, fixed electrodes 31 and movable electrodes 32 and support portions 23, 24, 25 and 26 to clearly indicate them.

Referring to FIGS. 8 to 10B, a diffraction grating-optical modulation element 21 shown includes a lower electrode 22, belt-shaped (ribbon-shaped) fixed electrodes 31 and belt-shaped (ribbon-shaped) movable electrodes 32. The lower electrode 22 is formed on a support member 12. Meanwhile, the fixed electrodes 31 are supported on the support portions 23 and 24 and extend above the lower electrode 22. The movable electrodes 32 are supported on the support portions 25 and 26 and extend above the lower electrode 22 in a juxtaposed relationship with the fixed electrodes 31. Each of the diffraction grating-optical modulation elements 21 is composed of three fixed electrodes 31 and three movable electrodes 32. The three movable electrodes 32 are collectively connected to a control electrode connected to a connection terminal section not shown. Meanwhile, the three fixed electrodes 31 are collectively connected to a bias electrode. The bias electrode is common to the plurality of diffraction grating-optical modulation elements 21 and is grounded through a bias electrode terminal section not shown. Also the lower electrode 22 is common to the plurality of diffraction grating-optical modulation elements 21 and is grounded through a lower electrode terminal section not shown.

If a voltage is applied to any movable electrode 32 through the connection terminal section and the control electrode and another voltage is applied to the lower electrode 22 (actually the lower electrode 22 is in a grounded state), then electrostatic force (Coulomb force) is generated between the movable electrode 32 and the lower electrode 22. The movable electrode 32 is displaced downwardly toward the lower electrode 22 by the electrostatic force. Based on such displacement of the movable electrode 32, a diffraction grating of the reflection type is formed from the movable electrode 32 and the fixed electrode 31.

Here, if the distance between adjacent ones of the fixed electrodes 31 is represented by d (refer to FIG. 10B), the wavelength of light (incident angle: $\theta_i$) incoming to the movable electrode 32 and the fixed electrode 31 by $\lambda$ and the diffraction angle by $\theta_m$, then the following expression is satisfied:

$$d[\sin(\theta_i) - \sin(\theta_m)] = m \cdot \lambda$$

where m is the order and assumes the values 0, $\pm 1$, $\pm 2$, ....

Thus, where the difference $\Delta h_1$ (refer to FIG. 10B) in height between the top face of the movable electrode 32 and the top face of the fixed electrode 31 is $\lambda/4$, the diffracted light exhibits a maximum intensity.

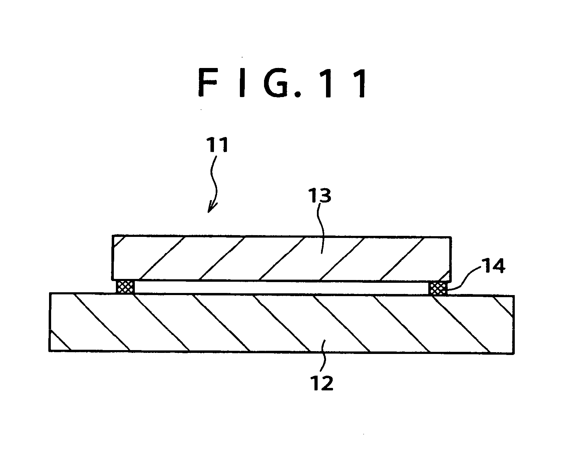

The diffraction grating-optical modulation apparatus 11 is formed such that a plurality of diffraction grating-optical modulation elements 21 are formed on the surface of the support member 12. FIG. 11 shows a conceptive sectional view of the diffraction grating-optical modulation apparatus 11. Referring to FIG. 11, the diffraction grating-optical modulation apparatus 11 further includes a light transmitting member 13 formed from a glass plate in the form of a flat plate. It is to be noted that, in FIG. 11, the diffraction grating-optical modulation elements are not shown. The support member 12 and the light transmitting member 13 are adhered to each other by a low-melting point metal material layer 14. The distance (L) from the surface of the support member 12 to the light transmitting member 13 is approximately 0.1 mm.

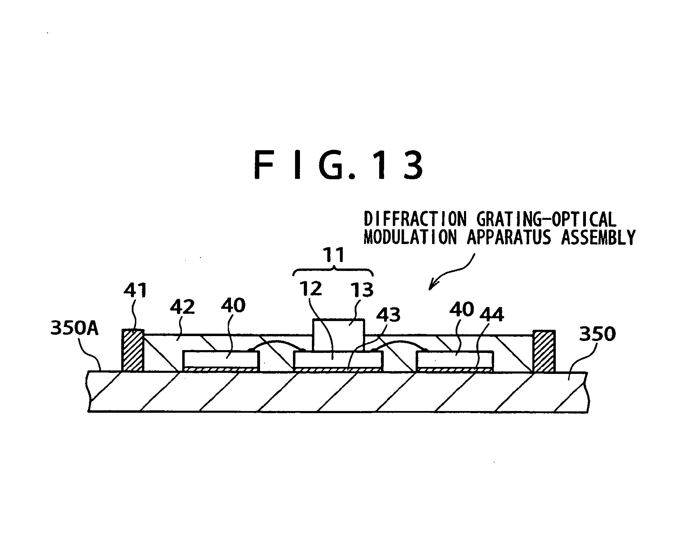

FIG. 13 shows a conceptive partial sectional view of a conventional image production apparatus. Referring to FIG. 13, the conventional image production apparatus includes, in addition to the diffraction grating-optical modulation apparatus 11, a mounting substrate 350 (more particularly, a printed circuit board formed, for example, from a glass epoxy copper-plated laminated plate) and a light source (not shown in FIG. 13). It is to be noted that an assembly of the diffraction grating-optical modulation apparatus 11 and the mounting substrate 350 is hereinafter referred to sometimes as diffraction grating-optical modulation apparatus assembly. A circuit for processing a signal inputted from the outside for driving the diffraction grating-optical modulation apparatus 11 and other circuits are provided on the mounting substrate 350. The support member 12 is attached to a face 350A of the mounting substrate 350 by bonding agent 43. The light source is formed as a laser light source which emits one of red light, green light and blue light which are the primaries of light.

Semiconductor chips 40 on which a circuit required to drive the diffraction grating-optical modulation apparatus 11 is formed are attached to the face 350A of the mounting substrate 350 by bonding agent 44. The diffraction grating-optical modulation apparatus 11 and semiconductor chips 40 and the semiconductor chips 40 and mounting substrate 350 are electrically connected, for example, by bonded wires. The diffraction grating-optical modulation apparatus 11 and the semiconductor chips 40 are surrounded by a framework member 41 and are embedded in a potting resin 42 to protect the bonded wires.

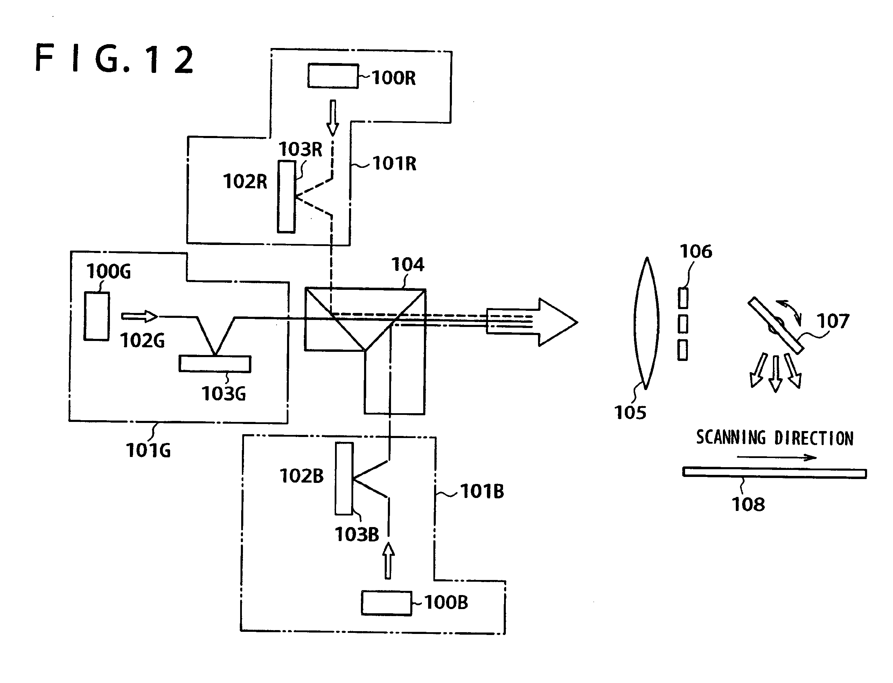

FIG. 12 shows a concept of the image forming apparatus. Referring to FIG. 12, the image forming apparatus includes three image production apparatus 101R, 101G and 101B. The image production apparatus 101R includes a diffraction grating-optical modulation apparatus assembly 102R and a laser light source (red light emitting semiconductor laser) 100R. The image production apparatus 101G includes a diffraction grating-optical modulation apparatus assembly 102G and a laser light source (green light emitting semiconductor laser) 100G. The image production apparatus 101B includes a diffraction grating-optical modulation apparatus assembly 102B and a laser light source (blue light emitting semiconductor laser) 100B. It is to be noted that a laser beam of red emitted from the laser light source (red light emitting semiconductor laser) 100R is indicated by a broken line and a laser beam of green emitted from the laser light source (green light emitting semiconductor laser) 100G is indicated by a solid line. Further, a laser beam of blue emitted from the laser light source (blue light emitting semiconductor laser) 100B is indicated by an alternate long and short dash line. The image forming apparatus further includes condenser lenses (not shown) for condensing the laser beams emitted from the laser light sources 100R, 100G and 100B and introducing the condensed laser beams into diffraction grating-optical modulation apparatus 103R, 103G and 103B (each having a configuration and structure same as those of the diffraction grating-optical modulation apparatus 11). The image forming apparatus further includes an L-shaped prism 104 for combining the laser beams emitted from the diffraction grating-optical modulation apparatus 103R, 103G and 103B into a single flux of light, and a lens 105 and a spatial filter 106 through which the combined flux of light of the primaries passes. The image forming apparatus further includes an image forming lens (not shown) for focusing the single flux of light having passed through the spatial filter 106 to form an image. The image forming apparatus further includes a scanning mirror (galvano mirror) 107 for scanning the single flux of light having passed through the image forming lens, and a screen 108 on which the light scanned by the scanning mirror 107 is projected. It is to be noted that, where a cylindrical lens is used for the condenser lenses, collimated beams of light condensed to a predetermined spot size in an X direction but collimated to a predetermined width in a Y direction can be introduced into the diffraction grating-optical modulation apparatus 103R, 103G and 103B. The spatial filter 106 is disposed, for example, on the Fourier plane.

In the image forming apparatus having such a configuration as described above, in an inoperative state of a diffraction grating-optical modulation element 21 wherein the movable electrode 32 is in a state shown in FIG. 9B and on the left side of FIG. 10B, light reflected by the top faces of the movable electrode 32 and the fixed electrode 31 is intercepted by the spatial filter 106. On the other hand, in an operative state of the diffraction grating-optical modulation element 21 wherein the movable electrode 32 is in a state shown in FIG. 10A and on the right side of FIG. 10B, $\pm$ first order (m = $\pm$1) diffracted light diffracted by the movable electrode 32 and the fixed electrode 31 passes through the spatial filter 106. Where the image forming apparatus is configured in this manner, on/off of light to be projected on the screen 108 can be controlled. Further, the difference $\Delta h_1$ in height between the top face of the movable electrode 32 and the top face of the fixed electrode 31 can be varied by varying the voltage to be applied to the movable electrode 32, and as a result, the intensity of the diffracted light can be varied to perform gradation control.

Since the movable electrode 32 is very small in size, a high resolution, a high speed switching operation and display of a wide bandwidth can be achieved with the diffraction grating-optical modulation apparatus. Further, since the diffraction grating-optical modulation apparatus operates with a low application voltage, it is anticipated to implement an image forming apparatus of a very small size. Further, since scanning is performed by the scanning mirror 107, such an image forming apparatus as described above can represent a very smooth and natural image when compared with a popular two-dimensional image production apparatus such as a projection type display apparatus which uses a liquid crystal panel or the like. Besides, since semiconductor lasers for red, green and blue light of the primaries are used and the light beams of them are mixed, the image forming apparatus has such a superior display performance which cannot be achieved by conventional image forming apparatus in that an image of a very wide natural color regeneration range can be represented.

Where such a high luminance as $10^4$ lumen is required for the diffraction grating-optical modulation apparatus 11 in such an application as a projector for a theater, the power of the laser beam illuminated upon the diffraction grating-optical modulation apparatus 11 has such a very high value as approximately 50 to 100 W. Accordingly, a great amount of heat is generated in the diffraction grating-optical modulation apparatus 11, and the heat is transferred to the mounting substrate 350, resulting in significant thermal expansion of the mounting substrate 350. It is to be noted that the thermal expansion of the mounting substrate 350 formed from a printed circuit board formed from a glass epoxy copper-plated laminated plate is, for example, approximately $3.1 \times 10^{-6}$ /K. Further, the Young's modulus of the mounting substrate 350 formed from a printed circuit board formed from a glass epoxy copper-plated laminated plate is, for example, approximately 25 GPa, and the mounting substrate 350 is considered very flexible.

If a great amount of thermal expansion occurs with the mounting substrate 350, then a displacement in position appears between the fixed electrodes 31 and the movable electrodes 32 which form the diffraction grating-optical modulation elements 21. As described hereinabove with reference to FIG. 12, in the image forming apparatus, one pixel is formed and displayed from laser beams (diffracted light of laser beams of red, blue and green) diffracted from the three diffraction grating-optical modulation apparatus 103R, 103G and 103B. Therefore, if a displacement in position appears between the fixed electrodes 31 and the movable electrodes 32 which form the diffraction grating-optical modulation elements 21, then a displacement occurs among the diffracted lights of laser beams emitted from the diffraction grating-optical modulation apparatus 103R, 103G and 103B for forming and displaying pixels. As a result, color blurring or the like occurs, and it is difficult to form a clean image. As reduction in size and enhancement of the resolution of a diffraction grating-optical modulation apparatus proceeds, the problem of such color blurring and so forth becomes further conspicuous.

SUMMARY OF THE INVENTION

It is an object of the present invention to provide an optical apparatus having a configuration and structure according to independent claims 1, 4, 6 by which, even if heat is generated with optical elements in a diffraction grating-optical modulation apparatus or the like, lights emitted from the optical elements are less likely to suffer from displacement therebetween.

According to the first aspect of the present invention according to claim 1, there is provided an optical apparatus, including:

an optical element;
a mounting substrate;
a support member; and
a cooling/heat radiating member;
the support member being attached to a first face of the mounting substrate;
the optical element being attached to a second face of the mounting substrate;
the cooling/heat radiating member being attached to the support member;
the optical element and the support member being thermally connected to each other by a heat transmission element provided in the inside of the mounting substrate;
the support member being made of a material having a thermal conductivity of 230 W/m·K or more.

According to the second aspect of the present invention as defined by claim 4, there is provided an optical apparatus, including:

an optical element;
a mounting substrate; and
a support member;
the mounting substrate having an opening formed therein;
the support member being attached to one face of the mounting substrate;
the optical element being attached to a portion of the support member which is exposed to the opening formed in the mounting substrate;
the support member being made of a material having a thermal conductivity of 230 W/m·K or more.

According to the third aspect of the present invention as defined by claim 6, there is provided an optical apparatus, including:

an optical element;
a mounting substrate; and
a support member;
the support member being attached to one face of the mounting substrate in such a manner as to extend from an edge portion of the mounting substrate to the outer side of the mounting substrate;
the optical member being attached to the portion of the support member which extends to the outer side of the mounting substrate;
the support member being made of a material having a thermal conductivity of 230 W/m·K or more.

According to the fourth aspect of the present invention, there is provided an image production apparatus, including:

a light source; and
an optical apparatus including an optical element for emitting light incoming from the light source, a mounting substrate, a support member, and a cooling/heat radiating member;
the support member being attached to a first face of the mounting substrate;
the optical element being attached to a second face of the mounting substrate;
the cooling/heat radiating member being attached to the support member;
the optical element and the support member being thermally connected to each other by a heat transmission element provided in the inside of the mounting substrate;
the support member being made of a material having a thermal conductivity of 230 W/m·K or more.

According to the fifth aspect of the present invention, there is provided an image production apparatus, including:

a light source; and
an optical apparatus including an optical element for emitting light incoming from the light source, a mounting substrate, and a support member;
the mounting substrate having an opening formed therein;
the support member being attached to one face of the mounting substrate;

the optical element being attached to a portion of the support member which is exposed to the opening formed in the mounting substrate;
the support member being made of a material having a thermal conductivity of 230 W/m·K or more.

According to the sixth aspect of the present invention, there is provided an image production apparatus, including:

a light source; and
an optical apparatus including an optical element for emitting light incoming from the light source, a mounting substrate, and a support member;
the support member being attached to one face of the mounting substrate in such a manner as to extend from an edge portion of the mounting substrate to the outer side of the mounting substrate;
the optical member being attached to the portion of the support member which extends to the outer side of the mounting substrate;
the support member being made of a material having a thermal conductivity of 230 W/m·K or more.

In the optical apparatus and the image production apparatus according to the first mode of the present invention, the optical element and the support member are thermally connected to each other by the heat transmission element provided in the inside of the mounting substrate. More particularly, the thermal connection is established such that the optical element and one end of the heat transmission element contact directly or indirectly with each other and the support member and the other end of the heat transmission element directly or indirectly contact with each other. Where the area of the portion of the optical element attached to the second face of the mounting substrate (that is, the area of the portion of the optical element which directly or indirectly contacts with the second face of the mounting substrate) is represented by $S_0$ and the sectional area of the heat transmission element for thermally connecting the optical element and the support member to each other along a plane parallel to the surface of the mounting substrate is represented by $S_1$ (where a plurality of such heat transmission elements are involved, the total area of the sectional areas of the transmission elements is represented by $S_1$), preferably the areas $S_0$ and $S_1$ satisfy a relationship of $0.01 \times S_0 \leqq S_1 \leqq 0.5 \times S_0$.

In the optical apparatus and the image production apparatus according to the second mode of the present invention, the optical element is attached to the portion of the support member which is exposed to the opening formed in the mounting substrate. The surface of the portion of the support member

(1) may be substantially in level with the one face of the mounting substrate,
(2) may be positioned in the inside of the opening formed in the mounting substrate,
(3) may be substantially in level with the other face of the mounting substrate, or
(4) may project from the other face of the mounting substrate.

It is to be noted that, in the case of any of (2) to (4), the portion of the support member which is positioned in the inside of the opening formed in the mounting substrate may sometimes be hereinafter referred to as support member projection.

In the optical apparatus and the image production apparatus according to the first mode of the present invention, the heat transmission element may be formed from a via hole for heat transmission formed in the inside of the mounting substrate. The optical apparatus may further include a semiconductor chip including a circuit necessary to drive the optical element, the semiconductor chip being attached to the second face of the mounting substrate. The via hole for heat transmission may be structured such that a through-hole formed in the inside of the mounting substrate is filled up with a material (for example, copper or silver) having a high heat conductivity. Also in the optical apparatus and the image production apparatus according to the second or third mode of the present invention, where a semiconductor chip including a circuit necessary to drive the optical element is attached to the other face of the mounting substrate, preferably the semiconductor chip and the support member are thermally connected to each other by a heat transmission element provided in the inside of the mounting substrate. Further preferably, the heat transmission element is formed from a via hole for heat transmission formed in the inside of the mounting substrate. Preferably, the via hole for heat transmission is configured such that it contacts at one end thereof directly or indirectly with the optical element and contacts at the other end thereof directly or indirectly with the support member. Further, preferably another via hole for heat transmission is configured such that it contacts at one end thereof directly or indirectly with the semiconductor chip and contacts at the other end thereof directly or indirectly with the support member.

In the optical apparatus and the image production apparatus according to the second mode of the present invention, the optical apparatus may further include a cooling/heat radiating member attached to the support member. The optical apparatus may further include a semiconductor chip including a circuit necessary to drive the optical element, the semiconductor chip being attached to the portion of the support member which is exposed to the opening formed in the mounting substrate.

In the optical apparatus and the image production apparatus according to the third mode of the present invention, the optical apparatus may further include a cooling/heat radiating member attached to the support member. The optical apparatus may further include a semiconductor chip including a circuit necessary to drive the optical element, the semiconductor chip being attached to the portion (which is hereinafter referred to sometimes as support member projection) of the support member which extends to the outer side of the mounting substrate.

As the circuit necessary to drive the optical element, for example, a 10- or 12-bit driver and a digital-analog converter (DAC) can be listed.

While, in the optical apparatus and the image production apparatus according to the first to third modes of the present invention, the support member is made of a material having a thermal conductivity of 230 W/m·K or more, the upper limit to the thermal conductivity of the support member may essentially be an arbitrary value. Here, preferably the support member is made of aluminum (Al), copper (Cu), a beryllium copper alloy, silver or gold. The thermal conductivities of the materials mentioned are listed in Table 1 hereinbelow. Alternatively, the support member is preferably made of a material of at least two materials selected from a group consisting of the materials mentioned. In this instance, a structure wherein the support member projection made of a certain material and the portion of the support member other than the support member projection made of another material are adhered to each other can be used. It is to be noted that the values of the thermal conductivity given below are those at 0°C.

[Table 1]

| | Thermal conductivity (W/m·K) |
|---|---|
| Al | 236 |
| Cu | 403 |
| Beryllium copper | 230 |
| Silver | 428 |
| Gold | 319 |

In the optical apparatus and the image production apparatus of the first to third modes of the present invention, the mounting substrate can be formed from a printed circuit board. As the printed circuit board, a rigid printed circuit board, a multilayer rigid printed circuit board and a multilayer flex rigid printed circuit board which have wiring lines formed on one or two faces thereof, a metal core printed circuit board and a multilayer metal core printed circuit board which have wiring lines formed on one or two faces thereof, and a metal base printed circuit board, a multilayer metal base printed circuit board, a buildup multilayer printed circuit board and a ceramics circuit board which have wiring lines formed on one or two faces thereof can be listed. The various printed circuit boards can be produced using a conventional production method. Such circuits may be formed by a subtractive method including a panel plating method and a pattern plating method or by an additive method such as a semi additive method or a full additive method. The configuration of a base member which forms the printed circuit board is essentially arbitrary, and the following can be exemplified: combinations of paper/phenol resin, paper/epoxy resin, glass fabric/epoxy resin, glass non-woven fabric/epoxy resin, glass fabric/glass non-woven fabric/epoxy resin, synthetic fiber/epoxy resin, glass fabric/polyimide resin, glass fabric/ modified polyimide resin, glass fabric/epoxy modified polyimide resin, glass fiber/bismaleimide/triazine/epoxy resin, glass fabric/fluorocarbon resin, glass fabric/PPO (polyphenylene oxide) resin, and glass fabric/PPE (polyphenylene ether).

In the optical apparatus according to the first to third modes of the present invention, said optical element is formed from a diffraction grating-optical modulation apparatus. Here, the diffraction grating-optical modulation apparatus is configured such that it includes a lower electrode, a belt-shaped fixed electrode supported above the lower electrode, and a belt-shaped movable electrode supported above the lower electrode in a juxtaposed relationship with the fixed electrode, a plurality of diffraction grating-optical modulation elements each of which includes a diffraction grating formed from the movable electrode and the fixed electrode as the movable electrode is displaced toward the lower electrode by electrostatic force generated through application of voltages to the movable electrode and the lower electrode and acting between the movable electrode and the lower electrode being formed on a surface of the support member.

It is to be noted that preferably the diffraction grating-optical modulation apparatus further includes a light transmitting member disposed in an opposing relationship to the fixed electrodes and the movable electrodes for transmitting therethrough incoming light which is to come into the fixed electrodes and the movable electrodes and outgoing light which goes out from the fixed electrodes and the movable electrodes.

The fixed electrodes and the movable electrodes which form the diffraction grating-optical modulation apparatus can be produced applying, for example, a micromachine technique. The diffraction gratings formed from the movable electrodes and the fixed electrodes act as diffraction gratings of the reflection type.

A silicon semiconductor substrate can be exemplified as a material for forming the support member in the diffraction grating-optical modulation apparatus.

As a material for forming the lower electrode and the bias electrodes of the diffraction grating-optical modulation apparatus, at least one metal selected from a group consisting of aluminum (Al), titanium (Ti), gold (Au), silver (Ag), tungsten (W), niobium (Nb), tantalum (Ta), molybdenum (Mo), chromium (Cr), copper (Cu), nickel (Ni), cobalt (Co), zirconium (Zr), iron (Fe), platinum (Pt) and zinc (Zn); an alloy or a compound which contains any of the metallic elements mentioned (for example, a nitride such as TiN or a silicide such as $WSi_2$, $MoSi_2$, $TiSi_2$, or $TaSi_2$); a semiconductor such as silicon (Si); and a conductive metal oxide such as ITO (indium tin oxide), indium oxide or zinc oxide can be exemplified. For production of the lower electrode or the bias electrodes, a known thin film formation method such as a CVD method, a sputtering method, a vapor deposition method, a liftoff method, an ion plating method, an electrolytic plating method, an electroless plating method, a screen printing method, a laser abrasion method, or a sol-gel method may be used to form a thin film of any of the materials mentioned above on the surface of the support member.

Further, the fixed electrodes and the movable electrodes of the diffraction grating-optical modulation elements preferably have a two-layer structure of a light reflecting layer (upper layer) and a dielectric material layer (lower layer). In particular, the two-layer structure may be, for example, a laminated structure of an aluminum layer (upper layer) and a SiN layer (lower layer), that of an aluminum layer (upper layer) and a $SiO_2$ layer (lower layer), that of an aluminum layer (upper layer) to which Si is added and a SiN layer (lower layer), that of an aluminum layer (upper layer and alloy layer of aluminum/copper) to which Cu is added and a SiN layer (lower layer) (as a rate of addition, 0.1 weight % to 5 weight % can be exemplified: this applies similarly in the following description), that of an aluminum layer (upper layer) to which Cu is added and a $SiO_2$ layer (lower layer), that of a titanium oxide layer (upper layer) and a SiN layer (lower layer), or that of a titanium oxide layer (upper layer) and a $SiO_2$ layer (lower layer). It is to be noted that the lower layer may have a two-layer configuration of a $SiO_2$ layer and a SiN layer.

Further, in the diffraction grating-optical modulation elements, supporting portions for supporting the fixed electrodes are preferably formed from extensions of the fixed electrodes, and supporting portions for supporting the movable electrodes are preferably formed from extensions of the movable electrodes.

In each of the diffraction grating-optical modulation elements, as the difference $\Delta h_0$ in height between the top face of the lower electrode and the top face of the fixed electrode, $3.0 \times 10^{-7}$ (m) to $1.5 \times 10^{-6}$ (m), preferably $4.5 \times 10^{-7}$ (m) to $1.2 \times 10^{-6}$ (m), can be exemplified. Further, the difference in height between the top face of the movable electrode and the top face of the fixed electrode when the diffraction grating-optical modulation element is inoperative preferably is as proximate as possible to zero. Furthermore, the maximum value $\Delta h_{1-MAx}$ of the difference $\Delta h_1$ (amount of the downward displacement of the movable electrode) in height between the top face of the movable electrode and the top face of the fixed electrode when the diffraction grating-optical modulation element is operative preferably satisfies

$$\lambda/4 \leqq \Delta h_{1-MAX}$$

where the wavelength of incoming light to the diffraction grating-optical modulation element or the diffraction grating-optical modulation apparatus is represented by $\lambda$.

Further, the relationship between $\Delta h_{1-MAX}$ and $\Delta h_0$ preferably satisfies

$$\Delta h_{1-MAX} \leqq (\Delta h_0/3)$$

It is to be noted that the difference $\Delta h_1$ (amount of the downward displacement of the movable electrode) in height between the top face of the movable electrode and the top face of the fixed electrode can be varied by varying the voltage to be applied to the movable electrode. Since this can vary the intensity of the diffracted light, gradation control can be performed.

Further, in the diffraction grating-optical modulation elements, the distance d between adjacent ones of the fixed electrodes preferably is, but is not limited to, $1 \times 10^{-6}$ (m) to $2 \times 10^{-5}$ (m), and more preferably $2 \times 10^{-6}$ (m) to $1 \times 10^{-5}$ (m). Further, the gap SP existing between any fixed electrode and an adjacent movable electrode (both of a gap within one diffraction grating-optical modulation element and a gap between adjacent ones of the diffraction grating-optical modulation elements) preferably is, but is not limited to, $1 \times 10^{-7}$ (m) to $2 \times 10^{-6}$ (m), and more preferably $2 \times 10^{-7}$ (m) to $5 \times 10^{-7}$ (m). Further, the width $W_F$ of the fixed electrodes is, but is not limited to, $1 \times 10^{-6}$ (m) to $1 \times 10^{-5}$ (m), and more preferably $2 \times 10^{-6}$ (m) to $5 \times 10^{-6}$ (m). Furthermore, the effective length $L_F$ of the fixed electrodes is, but is not limited to, $2 \times 10^{-5}$ (m) to $5 \times 10^{-4}$ (m), and more preferably $1 \times 10^{-4}$ (m) to $3 \times 10^{-4}$ (m). Meanwhile, the width $W_M$ of the movable electrodes is, but is not limited to, $1 \times 10^{-6}$ (m) to $1 \times 10^{-5}$ (m), and more preferably $2 \times 10^{-6}$

(m) to $5 \times 10^{-6}$(m). Further preferably, the width $W_M$ of the movable electrodes is equal to the width $W_F$ of the fixed electrodes. Further, the effective length $L_M$ of the movable electrodes preferably is, but is not limited to, $2 \times 10^{-5}$ (m) to $5 \times 10^{-4}$ (m), and more particularly $1 \times 10^{-4}$ (m) to $3 \times 10^{-4}$ (m). It is to be noted that the effective length $L_F$ of the fixed electrodes and the effective length $L_M$ of the movable electrodes signify the lengths of a portion of any fixed electrode and a portion of any movable electrode between supporting portions thereof in the configuration wherein each of the fixed electrode and the movable electrode is supported by the supporting portions.

Further, in the diffraction grating-optical modulation apparatus, the numbers of fixed electrodes and movable electrodes which form one diffraction grating-optical modulation element are not particularly limited although, where one fixed electrode and one movable electrode are regarded as a set, at least only one set is required. However, the number of such sets may be three in the maximum. Further, as the arrangement of a plurality of diffraction grating-optical modulation elements in the diffraction grating-optical modulation apparatus, they may be arranged in a one-dimensional array. In particular, the fixed electrodes and the movable electrodes which form the plurality of diffraction grating-optical modulation elements may be juxtaposed along a direction perpendicular to the axial direction of the fixed electrodes and the movable electrodes. The number of the diffraction grating-optical modulation elements may be determined based on the number of pixels required for the optical apparatus or the image production apparatus.

As a material for forming connection terminal sections of the diffraction grating-optical modulation apparatus for establishing electric connection to an external circuit and control electrodes for electrically connecting the connection terminal sections and the movable electrodes to each other, such materials used for the lower electrode and the bias electrodes as mentioned hereinabove can be used. Also the method of forming the connection terminal sections or the control electrodes may be a method similar to the method of forming the lower electrode and the bias electrodes described above. It is to be noted that the lower electrode, bias electrodes, connection terminal sections and control electrodes may be formed simultaneously, or the four different kinds of electrodes may be formed simultaneously in an arbitrary combination. Further, the film thickness of the electrodes may be made thicker separately.

The light transmitting member may be formed from a glass plate or a plastics plate, for example, a plate made of polymethyl methacrylate (PMMA) or polycarbonate (PC), but is preferably formed from a glass plate.

In the diffraction grating-optical modulation elements, the top face of each movable electrode and the top face of each fixed electrode may be in parallel to the top face of the lower electrode, or may be inclined by a blaze angle $\theta_D$ with respect to the top face of the lower electrode to form the diffraction grating-optical modulation elements as those of the blaze type so that, for example, only + first order diffracted light may be emitted. Where the diffraction grating-optical modulation elements of the blaze type are employed, an image can be displayed with a high diffraction efficiency of, for example, 60% or more. In applications to image forming apparatus such as a projector, the elements of the blaze type has the smooth response characteristic in the range between the dark level and the middle gradation to the applied voltage. It is also preferable to adopt diffraction grating-optical modulation elements of the blaze type by which image display of high gradations can be achieved readily.

In the optical apparatus and the image production apparatus according to the present invention, a heat sink, a Peltier device, a cooling apparatus which circulates water or coolant for cooling and a fan for forced blasting can be used as the cooling/heat radiating member.

Attachment of the support member to the first or one face of the mounting substrate in the optical apparatus and the image production apparatus according to the present invention, attachment of the optical element to the second or other face of the mounting substrate in the optical apparatus and the image production apparatus according to the first mode of the present invention, and attachment of the optical element to the support member in the optical apparatus and the image production apparatus according to the second or third mode of the present invention may be performed by a method which uses a bonding agent (for example, a method of applying a bonding agent of the thermosetting type and then heating the bonding agent to effect joining or adhesion). Meanwhile, attachment of the cooling/heat radiating member to the support member may be performed using screws or using a bonding agent (for example, a method of applying an ultraviolet curing resin and then illuminating ultraviolet rays on the resin to effect joining or adhesion).

In the image production apparatus according to the first to third modes of the present invention, a semiconductor laser can be used as the light source.

Excessive heat generated when light (laser beam) is illuminated on an optical element provided, for example, in a diffraction grating-optical modulation apparatus has a bad influence on the accuracy in position of a component of the optical element (for example, a diffraction grating-optical modulation element on a support member). Therefore, it is necessary to take a sufficient countermeasure against the heat. In the optical apparatus and the image production apparatus according to the first to third modes of the present invention, the support member is made of a material having a thermal conductivity of 230 W/m·K or more so that heat generated when light (laser beam) is illuminated upon the optical element (for example, the diffraction grating-optical modulation apparatus) is radiated through the support member. Consequently, the components of the optical element can be prevented from being influenced by the heat. Therefore, the problems of color blurring and so forth can be eliminated, and further reduction in size, further enhancement in performance, further increase in resolution and further improvement of the picture quality can be achieved by the image production apparatus. Further, the stability in operation of the optical element, optical apparatus and image production apparatus can be raised and the life of them can be increased.

Further, since heat generated when light (laser beam) is illuminated on the optical element is radiated through the support member, occurrence of a problem arising from a temperature gradient which is caused by a temperature rise of the optical element (for example, appearance of a void or hillock on the fixed electrodes or the movable electrodes) can be suppressed. Consequently, the durability of the optical element can be improved, and increase of the life of the optical element can be anticipated. It is to be noted that, where appearance of a void or hillock cannot be suppressed, there is the possibility that it may cause deterioration of the dark level, and in the worst case, to electric disconnection, malfunction or the like.

In the optical apparatus or the image production apparatus according to the second mode of the present invention, since the opening is provided in the mounting substrate and the optical element is attached to the portion of the support member which is exposed in the opening provided in the mounting substrate, not only simplification in structure can be anticipated, but also the degree of freedom in design is high.

Where a semiconductor chip on which a circuit necessary to drive the optical element is provided is attached to the support member, radiation of heat from and cooling of the semiconductor chip can be performed efficiently and besides a wiring process (wire bonding) is facilitated, which contributes to improvement in workability.

The above and other objects, features and advantages of the present invention will become apparent from the following description and the appended claims, taken in conjunction with the accompanying drawings in which like parts or elements are denoted by like reference symbols.

BRIEF DESCRIPTION OF THE DRAWINGS

FIG. 1A is a schematic partial sectional view of a diffraction grating-optical modulation apparatus assembly as an optical apparatus of an embodiment 1 of the present invention;
FIG. 1B is a schematic partial sectional view of a diffraction grating-optical modulation apparatus assembly as an optical apparatus as an embodiment 2 of the present invention;
FIG. 2A is a schematic partial sectional view of a diffraction grating-optical modulation apparatus assembly as an optical apparatus of an embodiment 3 of the present invention;
FIG. 2B is a schematic partial sectional view of a diffraction grating-optical modulation apparatus assembly as an optical apparatus according to a modification to the embodiment 2 of the present invention;
FIG. 3A is a schematic partial sectional view of a diffraction grating-optical modulation apparatus assembly as an optical apparatus of an embodiment 4 of the present invention;
FIG. 3B is a schematic partial plan view of a mounting substrate shown in FIG. 3A;
FIG. 4 is a schematic bottom plan view of the diffraction grating-optical modulation apparatus assembly as the optical apparatus of the embodiment 1 of the present invention;
FIG. 5A is a schematic partial sectional view of a mounting board in the diffraction grating-optical modulation apparatus assembly as the optical apparatus of the embodiment 2 of the present invention;
FIG. 5B is a schematic partial perspective view of the mounting board shown in FIG. 5A and a supporting member;
FIGS. 6A and 6B are schematic partial plan views of the mounting boards in the diffraction grating-optical modulation apparatus assembly as the optical apparatus of the embodiment 2 of the present invention and a modification to the diffraction grating-optical modulation apparatus assembly, respectively;
FIGS. 7A and 7B are schematic partial plan views of modifications to the mounting boards in the diffraction grating-optical modulation apparatus assembly as the optical apparatus of the embodiment 3 of the present invention and the modification to the diffraction grating-optical modulation apparatus assembly, respectively;
FIG. 8 is a view schematically showing arrangement of a lower electrode, fixed electrodes and movable electrodes which form a diffraction grating-optical modulation element;
FIG. 9A is a schematic sectional view taken along line B-B of FIG. 8 showing a fixed electrode and so forth;
FIG. 9B is a schematic sectional view taken along line A-A of FIG. 8 showing a movable electrode and so forth where the diffraction grating-optical modulation element is in an inoperative state;
FIG. 10A is a schematic sectional view taken along line A-A of FIG. 8 showing the movable electrode and so forth where the diffraction grating-optical modulation element is in an operative state;
FIG. 10B is a schematic sectional view taken along line C-C of FIG. 8 showing a fixed electrode, a movable electrode and so forth;
FIG. 11 is a conceptive sectional view showing part of a diffraction grating-optical modulation apparatus assembly;
FIG. 12 is a conceptive view of an image forming apparatus wherein three diffraction grating-optical modulation apparatus assemblies are combined; and

FIG. 13 is a schematic partial sectional view of a conventional diffraction grating-optical modulation apparatus assembly.

## DETAILED DESCRIPTION OF THE PREFERRED EMBODIMENTS

Before different embodiments of the present invention are described, a diffraction grating-optical modulation apparatus and a diffraction grating-optical modulation element which are employed commonly in the embodiments are described.

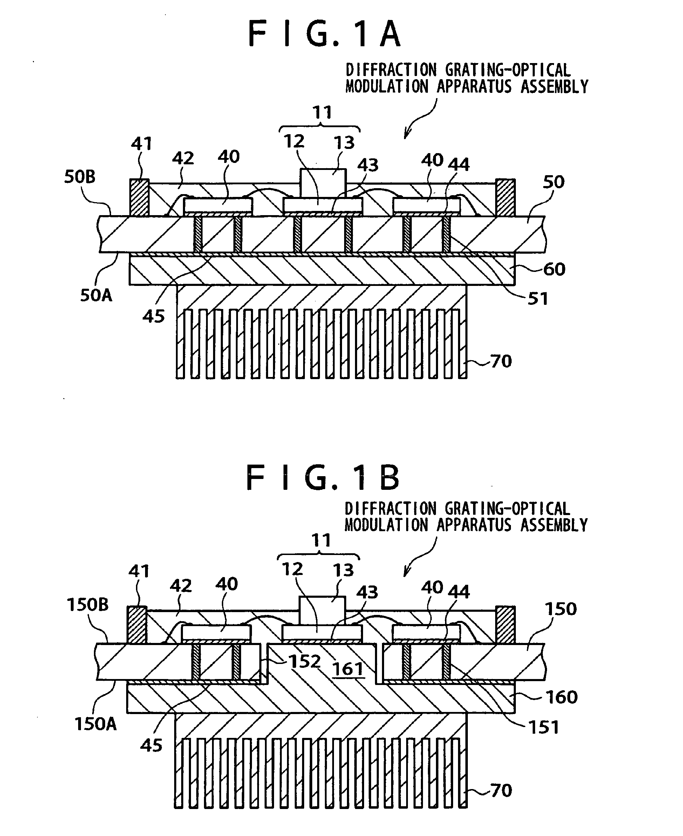

Referring to FIGS. 1A to 7B as well as FIGS. 8 to 13, the diffraction grating-optical modulation apparatus 11 used in the present invention includes a support member 12 and a plurality of (for example, 1,080) diffraction grating-optical modulation elements 21 formed on the surface of the support member 12 similarly to those of FIGS. 8, 9A, 9B, 10A and 10B. The diffraction grating-optical modulation apparatus 11 further includes a light transmitting member 13 formed from a glass plate. The diffraction grating-optical modulation elements 21 include a lower electrode 22, fixed electrodes 31 and movable electrodes 32. A light transmitting member 13 is disposed in an opposing relationship to the fixed electrodes 31 and the movable electrodes 32 and transmits therethrough incoming light which is to come into the fixed electrodes 31 and the movable electrodes 32 and outgoing light which goes out from the fixed electrodes 31 and the movable electrodes 32.

The lower electrode 22 is made of polycrystalline silicon doped with an impurity and is formed on the surface of the support member 12 formed from a silicon semiconductor substrate. It is to be noted that a protective insulating film (not shown) made of $SiO_2$ is formed on the surface of the lower electrode 22 so that the lower electrode 22 may not be damaged when the fixed electrodes 31 and the movable electrodes 32 are formed. The belt-shaped (ribbon-shaped) fixed electrodes 31 are supported on and extend above the lower electrode 22 and are juxtaposed with the fixed electrodes 31, and particularly are supported by support portions 25 and 26 which are extensions of the movable electrodes 32. The fixed electrodes 31 and the movable electrodes 32 have a laminated structure (rate of addition of Cu: 0.5 weight %) of a light reflecting layer (upper layer) made of aluminum to which Cu is added and a dielectric material layer (lower layer) made of SiN. It is to be noted that, in the figures, the fixed electrodes 31 and the movable electrodes 32 are represented in one layer.

A space defined by the diffraction grating-optical modulation apparatus 11 and the light transmitting member 13 is kept in an airtight state. Hydrogen gas, helium gas, nitrogen gas or mixed gas of them is enclosed in the space. This suppresses deterioration of the fixed electrodes 31 and the movable electrodes 32 arising from a temperature gradient caused by a temperature rise of the diffraction grating-optical modulation elements upon operation thereby to achieve improvement in durability and reliability.

The support member 12 and the light transmitting member 13 are joined together by a low-melting point metal material layer 14. The low-melting point metal material layer 14 may be formed at desired locations of a peripheral edge portion of the surface of the support member 12 and a peripheral edge portion of the light transmitting member 13. The layer 14 may be formed using a vacuum thin film forming technique such as vapor deposition, sputtering or ion plating. Under certain circumstances, a wire member or a foil member made of a metal material having a low melting point may be placed on or applied to desired locations of the support member 12 and so forth. The junction with the low-melting point metal material layer 14 is performed particularly by heating the low-melting point metal material layer 14. Specifically, heating of the low-melting point metal material layer 14 can be performed by a known heating method such as heating using a lamp, a laser, a furnace or the like.

The low-melting point metal material layer 14 may be made of a low-melting point metal material having a melting point of approximately 120 to 400°C. As such low-melting point metal material, a low-melting point alloy of the tin-gold type such as $Au_{80}Sn_{20}$ (melting point 260 to 320°C) can be listed. Also, In (Indium: melting point 157°C); high temperature solders of the tin (Sn) type such as $Sn_{80}Ag_{20}$ (melting point 220 to 370°C) and $Sn_{95}Cu_5$ (melting point 227 to 370°C); high temperature solders of the lead (Pb) such as $Pb_{97.5}Ag_{2.5}$ (melting point 304°C), $Pb_{94 \cdot s}Ag_{5 \cdot 5}$ (melting point 304 to 365°C) and $Pb_{97.5}Ag_{1.5}Sn_{1 \cdot 0}$ (melting point 309°C); high temperature solders of the zinc (Zn) type such as $Zn_{95}Al_5$ (melting point 380°C); standard solders of the tin-lead type such as $Sn_5Pb_{95}$ (melting point 300 to 314°C) and $Sn_2Pb_{98}$ (melting point 316 to 322°C); and solder materials such as $Au_{88}Ga_{12}$ (melting point 381°C) may be used.

The arrangement of the plurality of diffraction grating-optical modulation elements 21 in the diffraction grating-optical modulation apparatus 11 is a one-dimensional array. More particularly, the fixed electrodes 31 and the movable electrodes 32 which form the plurality of (for example, 1,080) diffraction grating-optical modulation elements 21 are juxtaposed along a direction (Y direction) perpendicular to the axial direction (X direction) of the fixed electrodes 31 and the movable electrodes 32. The total number of the fixed electrodes 31 and the movable electrodes 32 is, for example, 1,080 × 6.

It is to be noted that connection terminal sections (not shown) are provided for electric connection to semiconductor chips 40 on which, for example, a circuit necessary to drive the diffraction grating-optical modulation apparatus 11 is provided such that it is exposed to the outside, and are electrically connected to the movable electrodes 32. More particularly, each of the diffraction grating-optical modulation elements 21 is composed of three fixed electrodes 31 and three movable electrodes 32. The three movable electrodes 32 are collectively connected to a single control electrode, which is connected to a corresponding one of the connection terminal sections. Meanwhile, the three fixed electrodes 31 are collectively connected to a bias electrode, which is provided commonly to the plurality of diffraction grating-optical modulation elements 21. The bias electrode is connected to the semiconductor chips 40 through a bias electrode terminal portion (not shown), which is an extension of the bias electrode, and is grounded. Also the lower electrode 22 is common to the plurality of diffraction grating-optical modulation elements 21. The lower electrode 22 is connected to the semiconductor chips 40 through a lower electrode terminal portion (not shown), which is an extension of the lower electrode 22, and is grounded.

The connection terminal sections, lower electrode terminal section and bias electrode terminal section (not shown) are provided in a region of the support member 12 on the outer side with respect to the low-melting point metal material layer 14 (refer to FIG. 11). Wiring lines for connecting the terminal sections mentioned and various electrodes (for example, control electrodes, bias electrodes and so forth) have a structure which prevents short-circuiting of the wiring lines by the low-melting point metal material layer 14 (for example, the control electrodes and the bias electrodes are coated with an insulating material layer).

If a voltage is applied to any of the movable electrodes 32 while another voltage is applied to the lower electrode 22 from the external circuit through the connection terminal sections, then electrostatic force (Coulomb force) acts between the movable electrode 32 and the lower electrode 22 so that the movable electrode 32 is displaced toward the lower electrode 22. More particularly, if a voltage is applied to the movable electrode 32 through the connection terminal section and the control electrode from the external circuit and another voltage is applied to the lower electrode 22 through the lower electrode terminal section from the external circuit (actually the lower electrode 22 is in a grounded state), then electrostatic force (Coulomb force) is generated between the movable electrode 32 and the lower electrode 22. Then, the movable electrode 32 is displaced downwardly toward the lower electrode 22 by the electrostatic force. It is to be noted that the movable electrodes 32 and the lower electrode 22 at a stage before the displacement of the movable electrodes 32 are shown on the left side in FIGS. 9B and 10B, and the movable electrodes 32 and the lower electrode 22 at another state after the displacement of the movable electrodes 32 are shown on the right side of FIGS. 10A and 10B. Based on such displacement of the movable electrode 32, a diffraction grating of the reflection type is formed from the movable electrode 32 and the fixed electrode 31.

The difference $\Delta h_0$ in height between the top face of the lower electrode 22 and the top face of the fixed electrode 31 was set to a value given in Table 2 below. Further, the difference in height between the top face of the movable electrode 32 and the top face of the fixed electrode 31 when the diffraction grating-optical modulation element 21 is inoperative is set to a value as proximate as possible to zero. Furthermore, the maximum value $\Delta h_{1\text{-}MAX}$ of the difference $\Delta h_1$ (amount of the downward displacement of the movable electrode 32) in height between the top face of the movable electrode 32 and the top face of the fixed electrode 31 when the diffraction grating-optical modulation element 21 is operative satisfies

$$\Delta h_{1\text{-}MAX} = \lambda/4$$

where the wavelength of incoming light to the diffraction grating-optical modulation element 21 or the diffraction grating-optical modulation apparatus 11 is represented by $\lambda$.
Further, the relationship between $\Delta h_{1\text{-}MAX}$ and $\Delta h_0$ satisfies

$$\Delta h_{1\text{-}MAX} \leqq \Delta h_0/3$$

It is to be noted that the difference $\Delta h_1$ (amount of the downward displacement of the movable electrode 32) in height between the top face of the movable electrode 32 and the top face of the fixed electrode 31 can be varied by varying the voltage to be applied to the movable electrode 32. Since this can vary the intensity of the diffracted light, gradation control can be performed.

Further, the distance d between adjacent ones of the fixed electrodes 31, the gap SP existing between any fixed electrode and an adjacent movable electrode, the width $W_F$ of the fixed electrodes 31, the effective length $L_F$ of the fixed electrodes 31, the width $W_M$ of the movable electrodes 32 and the effective length $L_M$ of the movable electrodes 32 are set to such values as given in Table 2 below. The unit in Table 2 is $\mu$m.

[Table 2]
$\Delta h_0 = 0.85$
$d = 8.0$
$SP = 0.40$
$W_F = 3.6$
$L_F = 200$
$W_M = 3.6$
$L_M = 200$

An image forming apparatus including the three image production apparatus 101R, 101G and 101B which in turn include the diffraction grating-optical modulation apparatus assemblies 102R, 102G and 102B, which include such diffraction grating-optical modulation apparatus 103R, 103G and 103B (having a configuration and structure same as those of the diffraction grating-optical modulation apparatus 11) as described above, and the light sources (laser light sources 100R, 100G and 100B), respectively, may conceptively have a configuration similar to that described hereinabove with reference to FIG. 12. Also operation of the image forming apparatus which includes the three image production apparatus 101R, 101G and 101B is similar to that described hereinabove with reference to FIG. 12. Therefore, detailed description of the configuration and structure and the operation of the image forming apparatus is omitted herein to avoid redundancy.

Embodiment 1

An embodiment 1 relates to an optical apparatus and an image production apparatus according to claim 1.

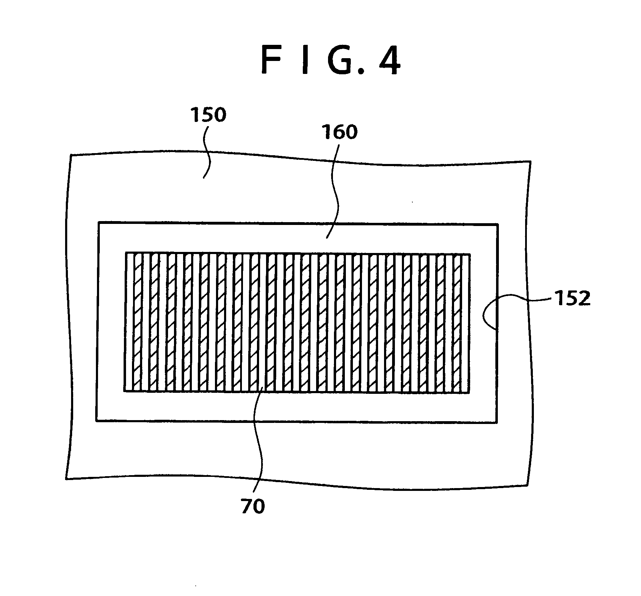

The optical apparatus of the embodiment 1 includes an optical element wherein a plurality of diffraction grating-optical modulation elements (GLV) are arrayed in a one-dimensional array. It is to be noted that, in the following description, the optical element is sometimes referred to as diffraction grating-optical modulation apparatus and the optical apparatus is sometimes referred to as diffraction grating-optical modulation apparatus assembly. Further, the image forming apparatus of the embodiment 1 includes the optical apparatus (diffraction grating-optical modulation apparatus assembly) and a light source (semiconductor laser) similarly to that shown in FIG. 12. A schematic partial sectional view of the optical apparatus (diffraction grating-optical modulation apparatus assembly) of the embodiment 1 is shown in FIG. 1A, and a schematic bottom plan view of the optical apparatus (diffraction grating-optical modulation apparatus assembly) is shown in FIG. 4. It is to be noted that, in FIGS. 1A, 1B, 2A, 2B and 3A, a diffraction grating-optical modulation element and so forth are omitted.

More particularly, the optical apparatus (diffraction grating-optical modulation apparatus assembly) of the embodiment 1 includes

(A) diffraction grating-optical modulation apparatus 11;
(B) a mounting substrate 50,
(C) a support member 60, and
(D) a cooling/heat radiating member 70 formed from a heat sink.

The support member 60 is attached by bonding agent 45 for die bonding to a face 50A of the mounting substrate 50 which is formed from a printed circuit board formed from a glass epoxy copper-plated laminated plate. Meanwhile, the diffraction grating-optical modulation apparatus 11 is connected to the other face 50B of the mounting substrate 50 by bonding agent 43 for die bonding. It is to be noted that a circuit for processing a signal inputted from the outside for driving the diffraction grating-optical modulation apparatus and other necessary circuits are provided on the mounting substrate 50. This similarly applies also to embodiments 2 to 4 hereinafter described. Further, the cooling/heat radiating member 70 is attached to the support member 60 by means of screws or a bonding agent. The support member 60 functions as a joining plate for the cooling/heat radiating member 70 formed from a heat sink. The diffraction grating-optical modulation apparatus assembly can be attached to a body section of the image forming apparatus by means of screws, a bonding agent or the like.

The diffraction grating-optical modulation apparatus assembly in the embodiment 1 further includes semiconductor chips 40 on which a circuit (for example, a 10-bit or 12-bit driver) necessary to drive the diffraction grating-optical modulation apparatus 11 is provided. The semiconductor chips 40 is attached to the face 50B of the mounting substrate 50 by bonding agent 44 for die bonding.

It is to be noted that, upon bonding wherein the bonding agent 43, 44 or 45 is used, it can be used for bonding by heating it, for example, to 130 to 200°C although this depends upon the specifications of the bonding agent 43, 44 or 45. This similarly applies to the embodiments 2 and 4 hereinafter described.

In the embodiment 1, the support member 60 is made of a material having a thermal conductivity of 230 W/m·K, particularly an aluminum (Al) plate having a thickness (t) of 4 mm. More particularly, the support member 60 made of aluminum can be produced by cutting.

The diffraction grating-optical modulation apparatus 11 and the support member 60 are thermally connected to each other by a heat transmission element provided in the inside of the mounting substrate 50, particularly by heat transmitting via holes 51. The heat transmitting via holes 51 can be obtained by forming through-holes in the mounting substrate 50 and filling a material (for example, copper or silver) having a high thermal conductivity into the through-holes. More particularly, a method of filling a paste-like material (for example, copper paste or silver paste) having a high thermal conductivity into the through-holes by a screen printing method and a method of filling a material (for example, copper) having a high thermal conductivity by a plating method can be used. One end of each of the heat transmitting via holes 51 contacts indirectly (that is, through the bonding agent 43 or 44) with the optical element (more particularly, with the support member 12 which composes the diffraction grating-optical modulation apparatus 11) or contacts with a semiconductor chip 40. The other end of the heat transmitting via hole 51 contacts indirectly (that is, through the bonding agent 45) with the support member 60.

Further, the diffraction grating-optical modulation apparatus 11 and the semiconductor chips 40, and the semiconductor chips 40 and wiring lines provided on the mounting substrate 50, are electrically connected to each other, for example, by bonded wires. The diffraction grating-optical modulation apparatus 11 and the semiconductor chips 40 are surrounded by a framework member 41 (made of a thermosetting resin material). Further, the diffraction grating-optical modulation apparatus 11 and the semiconductor chips 40 are enclosed in potting resin 42 to protect the bonded wires thereof. Where the diffraction grating-optical modulation apparatus 11 and semiconductor chips 40, and the semiconductor chips 40 and wiring lines provided on the mounting substrate 50 are electrically connected to each other by bonded wires in this manner, the diffraction grating-optical modulation apparatus assembly can be formed in a reduced size and with a reduced weight.

In the embodiment 1 and also in the embodiments 2 to 4 hereinafter described, the light transmitting member 13 formed from a glass plate in the form of a flat plate and the support member 12 are joined (attached) together as shown conceptually in FIG. 11 by a low-melting point metal material layer 14 made of $Au_{80}Sn_{20}$.

In the embodiment 1, since the support member 60 is used and besides the heat transmitting via holes 51 are provided, heat from the diffraction grating-optical modulation apparatus 11 and heat from the semiconductor chips 40 can be transmitted efficiently to the cooling/heat radiating member 70. Besides, a high degree of accuracy in position of the diffraction grating-optical modulation element 21, which is difficult where only a mounting substrate 350 which has a high coefficient of linear expansion (for example, approximately $14 \times 10^{-6}$ /K, which is higher than the coefficient of linear expansion $3.1 \times 10^{-6}$ /K of the support member 12), and has a Young's modulus of approximately 25 GPa and is very flexible, can be assured sufficiently in the embodiment 1 using the support member 60.

Where thermal resistance values (unit: °C/W) were calculated with regard to the optical apparatus (diffraction grating-optical modulation apparatus assembly) of the embodiment 1, such values as listed in Table 3 below were obtained. Further, results of calculation of the thermal resistance value with regard to the conventional apparatus shown in FIG. 13 are listed as those of a comparative example 1 in Table 3. Further, results of calculation of the thermal resistance value with regard to the structure of the embodiment 1 where the heat transmitting via holes 51 are not provided are listed as those of a comparative example 2 in Table 3. It is to be noted that $S_1$ and $S_0$ have a relationship of $S_1 = 0.1 \times S_0$.

Table 3

| | Embodiment 1 | Comparative Example 1 | Comparative Example 2 |
|---|---|---|---|
| Diffraction Grating-Optical Modulation Apparatus 11 | 0.022 | 0.022 | 0.022 |
| Bonding Agent 43 | 0.440 | 0.440 | 0.440 |
| Mounting Substrate 250 | --- | 7.85 | 7.85 |
| Heat transmitting Via Hole 51 | 0.000 | --- | --- |
| Bonding Agent 45 | 0.085 | --- | 0.085 |
| Support Member 60 | 0.049 | --- | 0.049 |
| Total | 0.596 | 8.31 | 8.45 |

From Table 3, it can be discriminated that, where the support member 60 is made of a material having a thermal conductivity of 230 W/m·K or more and the optical element (diffraction grating-optical modulation apparatus 11) and the support member 60 are thermally connected to each other by the heat transmission means (heat transmitting via holes 51) provided in the mounting substrate 50, the thermal resistance value in the overall system in the embodiment 1 can be reduced to approximately 1/14 when compared with that in the comparative example 1.

Embodiment 2

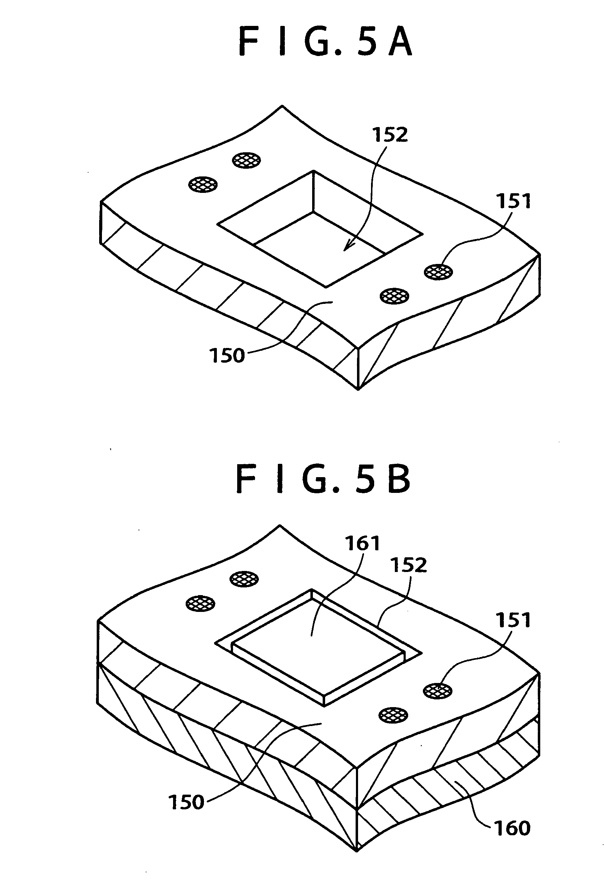

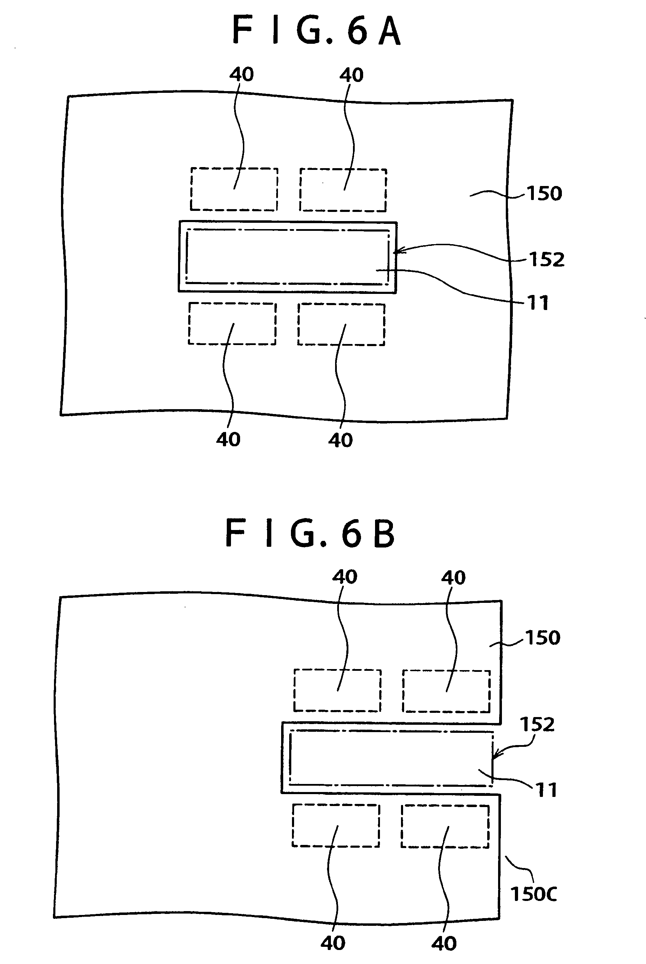

An embodiment 2 relates to an optical apparatus and an image forming apparatus according to claim 4. The optical apparatus of the embodiment 2 includes diffraction grating-optical modulation apparatus wherein a plurality of diffraction grating-optical modulation elements (GLV) are arrayed in a one-dimensional array. Also the image production apparatus of the embodiment 2 includes the diffraction grating-optical modulation apparatus assembly and a light source (semiconductor laser) similarly to that described hereinabove with reference to FIG. 12. A schematic partial sectional view of the optical apparatus (diffraction grating-optical modulation apparatus assembly) of the embodiment 2 is shown in FIG. 1B, and a schematic partial perspective view of a mounting substrate of the optical apparatus (diffraction grating-optical modulation apparatus assembly) is shown in FIG. 5A. Further, a schematic partial perspective view of the mounting substrate and a support member of the optical apparatus (diffraction grating-optical modulation apparatus assembly) is shown in FIG. 5B, and a schematic partial plan view of the mounting substrate is shown in FIG. 6A. It is to be noted that, in FIGS. 6A, 6B, 7A, 7B and 3B, the position at which a diffraction grating-optical modulation apparatus is to be disposed is indicated by an alternate long and short dash line, and the position at which a semiconductor chip is to be disposed is indicated by a broken line.

More particularly, the optical apparatus (diffraction grating-optical modulation apparatus assembly) of the embodiment 2 includes

    (A) diffraction grating-optical modulation apparatus 11,
    (B) a mounting substrate 150, and
    (C) a support member 160.

The mounting substrate 150 is formed from a printed circuit board formed from a glass epoxy copper-plated laminated plate and has an opening 152 formed therein. The support member 160 is attached to a face 150A of the mounting substrate 150 by bonding agent 45 for die bonding similarly as in the embodiment 1. The diffraction grating-optical modulation apparatus 11 is attached to a portion (support member projection 161) of the support member 160, which is exposed to the outside through the opening 152 formed in the mounting substrate 150, by bonding agent 43 for die bonding. The surface of the support member projection 161 is substantially in flush with the other face 150B of the mounting substrate 150. Further, the cooling/heat radiating member 70 formed from a heat sink is attached to the support member 160 by means of screws or bonding agent although this is not essential.

The diffraction grating-optical modulation apparatus assembly in the embodiment 2 further includes semiconductor chips 40 which in turn include each a circuit (for example, a 10- or 12-bit driver) required to drive the diffraction grating-optical modulation apparatus 11. The semiconductor chips 40 are attached to the face 150B of the mounting substrate 150 by bonding agent 44 for die bonding. Further, the semiconductor chips 40 and the support member 160 are thermally connected to each other by heat transmission means provided in the mounting substrate 150, particularly heat transmitting via holes 151 provided in the mounting substrate 150. Each of the heat transmitting via holes 151 contacts at one end thereof indirectly (that is, through the bonding agent 44) with a semiconductor chip 40, and contacts at the other end thereof indirectly (that is, through bonding agent 45) with the support member 160.

Also in the embodiment 2, the support member 160 is formed from a material having a thermal conductivity of 230 W/m·K or more, more particularly from an aluminum (Al) plate which has a thickness of 4 mm at the support member projection 161 thereof but has another thickness of 1.6 mm at the other portion thereof. More particularly, the support member 160 made of aluminum can be formed by cutting.

Also in the embodiment 2, the diffraction grating-optical modulation apparatus 11 and the semiconductor chips 40, and the semiconductor chips 40 and circuits as wiring lines provided on the mounting substrate 150, are electrically connected to each other by bonded wires. The diffraction grating-optical modulation apparatus 11 and the semiconductor chips 40 are surrounded by a framework member 41 (made of a thermosetting resin material) and are embedded in potting resin 42 to protect the bonded wires. Where the diffraction grating-optical modulation apparatus 11 and the semiconductor chips 40, and the semiconductor chips 40 and the circuits as wiring lines, are electrically connected to each other by the bonded wires in this manner, the diffraction grating-optical modulation apparatus can be formed in a reduced size and with a reduced weight.

In the embodiment 2, since the diffraction grating-optical modulation apparatus 11 is attached to the portion (support member projection 161) of the support member 160 which is exposed in the opening 152 formed in the mounting substrate 150, heat from the diffraction grating-optical modulation apparatus 11 can be radiated efficiently. Consequently, a high degree of accuracy in position of the diffraction grating-optical modulation element 21 can be assured sufficiently.

The thermal resistance value was calculated with regard to the optical apparatus (diffraction grating-optical modulation apparatus assembly) of the embodiment 2. The calculation indicated that the thermal resistance values (unit: °C/W) of the locations exhibited substantially equal values as those listed in Table 3 and representing the values obtained from the embodiment 1 (more particularly, values increasing by 0.002°C/W).

It is to be noted that the opening 152 may be provided in a region spaced away from an edge of the mounting substrate 150 as seen in FIG. 6A or may be provided like a cutaway portion along an edge portion 150C of the mounting substrate 150 as seen in FIG. 6B.

Embodiment 3

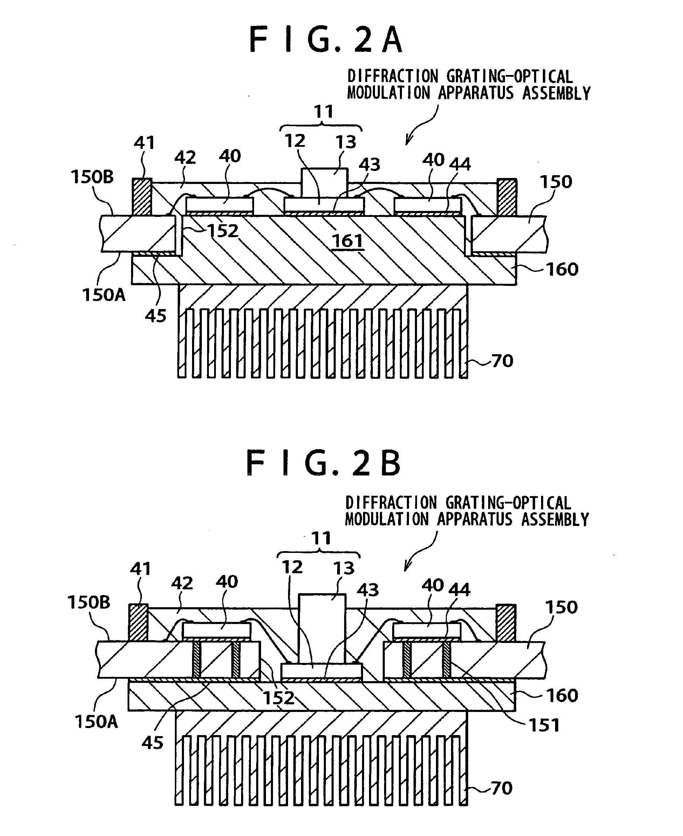

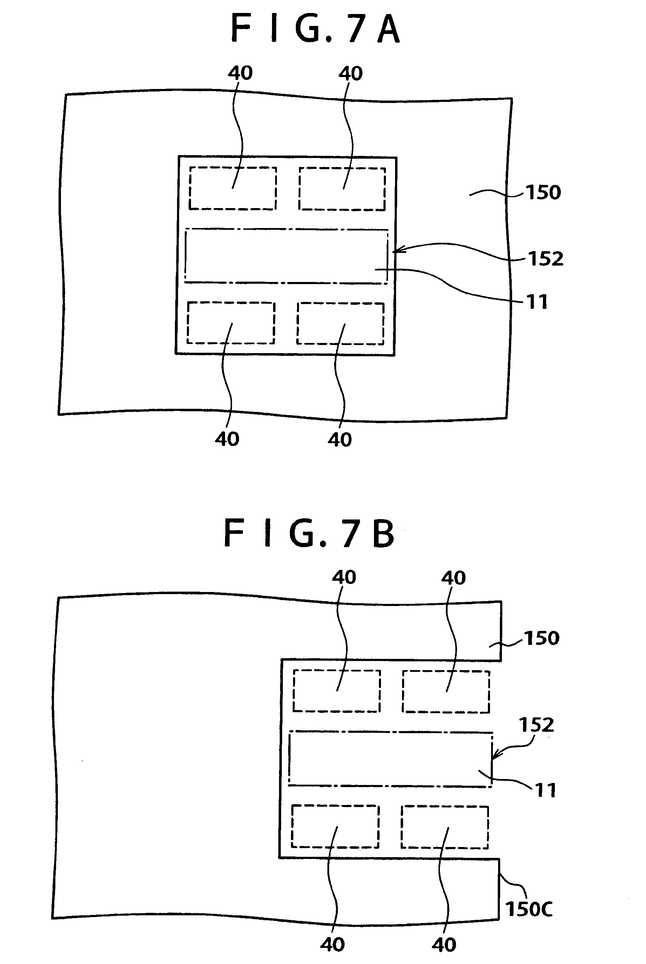

An embodiment 3 is a modification to the embodiment 2. In the embodiment 2, the semiconductor chips 40 are attached to the face 150B of the mounting substrate 150. On the other hand, in the embodiment 3, the semiconductor chips 40 are attached to the portion (support member projection 161) of the support member 160 exposed in the opening 152 formed in the mounting substrate 150 by means of bonding agent 44 for die bonding as seen in FIG. 2A which shows a schematic partial sectional view of the optical apparatus (diffraction grating-optical modulation apparatus assembly). It is to be noted that a schematic partial perspective view of the mounting substrate 150 is the same as that shown in FIG. 5A, and a schematic partial perspective view of the mounting substrate 150 and the support member 160 is similar to that shown in FIG. 5B. A schematic partial plan view of the mounting substrate 150 is shown in FIG. 7A.

Except such an attached state of the semiconductor chips 40 as just described, the configuration and structure of the optical element (diffraction grating-optical modulation apparatus), optical apparatus (diffraction grating-optical modulation apparatus assembly) and image production apparatus are the same as those described hereinabove in connection with the embodiment 2. Therefore, overlapping description of them is omitted herein to avoid redundancy.

It is to be noted that the opening 152 may be provided in a region spaced away from an edge of the mounting substrate 150 as seen in FIG. 7A or may be provided in the form of a cutaway portion along the edge portion 150C of the mounting substrate 150.

Embodiment 4

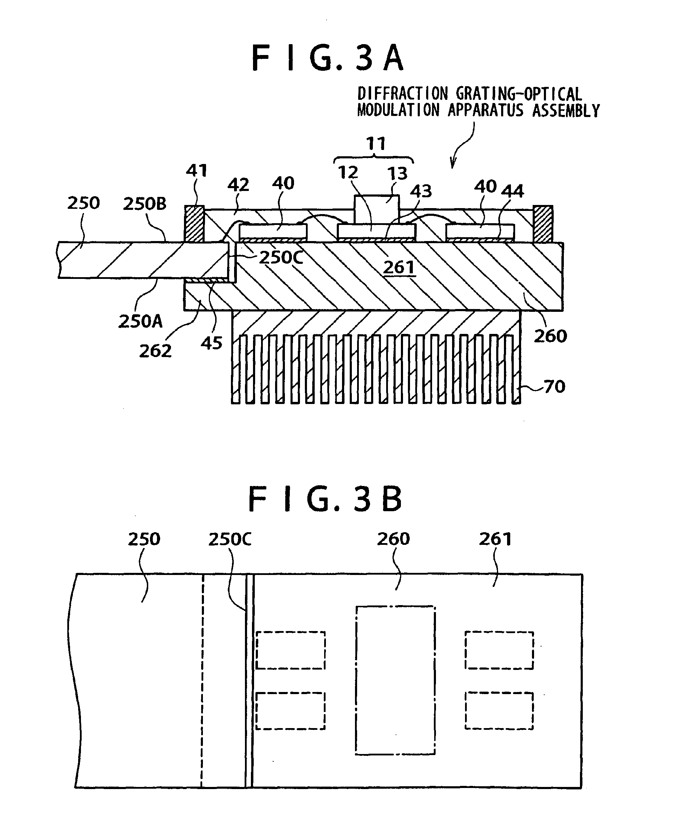

An embodiment 4 relates to an optical apparatus and an image production apparatus according to claim 6. The optical apparatus of the embodiment 4 particularly includes a diffraction grating-optical modulation apparatus wherein a plurality of diffraction grating-optical modulation elements (GLV) are arranged in a one-dimensional array. Also the image forming apparatus of the embodiment 4 includes a diffraction grating-optical modulation apparatus assembly and a light source (semiconductor laser) similarly to the apparatus shown in FIG. 12. A schematic partial sectional view of the optical apparatus (diffraction grating-optical modulation apparatus assembly) of the embodiment 4 is shown in FIG. 3A, and a schematic partial plan view of a mounting substrate and a support member is shown in FIG. 3B.

More particularly, the optical apparatus (diffraction grating-optical modulation apparatus assembly) of the embodiment 4 includes, similarly as in the embodiment 2,

(A) an optical element (diffraction grating-optical modulation apparatus 11),
(B) a mounting substrate 250, and
(C) a support member 260.

The support member 260 is attached to a face 250A of the mounting substrate 250 by bonding agent 45 for die bonding such that it extends from an edge portion 250C of the mounting substrate 250, which is formed from a glass epoxy copper-plated laminated plate, to the outer side of the mounting substrate 250. Meanwhile, the optical element (diffraction grating-optical modulation apparatus 11) is attached to a portion (support member projection 261) of the support member 260, which extends to the outer side of the mounting substrate 250, by bonding agent 43 for die bonding. Further, the cooling/heat radiating member 70 formed from a heat sink is attached to the support member 260 by means of screws or a bonding agent although this is not essential.

The diffraction grating-optical modulation apparatus assembly in the embodiment 4 further includes semiconductor chips 40 on each of which a circuit (for example, a 10- or 12-bit driver) necessary to drive the diffraction grating-optical modulation apparatus 11 is provided. The semiconductor chips 40 are attached to the support member 260 by bonding agent 44 for die bonding.

Also in the embodiment 4, the support member 260 is formed from a material having a thermal conductivity of 230 W/m·K or more, more particularly from an aluminum (Al) plate which has a thickness of 4 mm at the support member projection 261 thereof but has another thickness of 1.6 mm at the other portion thereof. More particularly, the support member 260 made of aluminum can be formed by cutting.

Also in the embodiment 4, the diffraction grating-optical modulation apparatus 11 and the semiconductor chips 40, and the semiconductor chips 40 and circuits as wiring lines provided on the mounting substrate 150, are electrically connected to each other by bonded wires. The diffraction grating-optical modulation apparatus 11 and the semiconductor chips 40 are surrounded by a framework member 41 (made of a thermosetting resin material) and are embedded in potting resin 42 to protect the bonded wires. Where the diffraction grating-optical modulation apparatus 11 and the semiconductor chips 40, and the semiconductor chips 40 and the circuits as wiring lines, are electrically connected to each other by the bonded wires in this manner, the diffraction grating-optical modulation apparatus can be formed in a reduced size and with a reduced weight.

In the embodiment 4, since the diffraction grating-optical modulation apparatus 11 is attached to the support member projection 261, heat from the diffraction grating-optical modulation apparatus 11 can be radiated efficiently. Consequently, a high degree of accuracy in position of the diffraction grating-optical modulation element 21 can be assured sufficiently.

The thermal resistance value was calculated with regard to the optical apparatus (diffraction grating-optical modulation apparatus assembly) of the embodiment 4. The calculation indicated that the thermal resistance values (unit: °C/W) of the locations exhibited substantially equal values as those obtained from the embodiment 2.

Except the foregoing, the configuration and structure of the optical apparatus (diffraction grating-optical modulation apparatus assembly) of the embodiment 4 may be same as those described hereinabove in connection with the embodiment 2. Therefore, overlapping description of them is omitted herein to avoid redundancy.

It is to be noted that the semiconductor chips 40 may be attached otherwise to the other face 250B of the mounting substrate 250 by means of bonding agent for die bonding. In this instance, the semiconductor chips 40 and the support member 260 are preferably thermally connected to each other by heat transmission means provided in the mounting substrate 250, particularly by via holes for heat transmission. The via holes for heat transmission can be configured such that each of them contacts at one end thereof indirectly (that is, through the bonding agent) with a semiconductor chip 40 and at the other end thereof indirectly (that is, through the bonding agent 45) with the support member 260.

While the present invention is described in connection with preferred embodiments thereof, the present invention is not limited to them. The structures and configurations of the diffraction grating-optical modulation elements, optical elements (diffraction grating-optical modulation apparatus), optical apparatus (diffraction grating-optical modulation apparatus assemblies) and image production apparatus are merely illustrative and can be altered suitably. Also the materials which form the various members of the diffraction grating-optical modulation apparatus assemblies, diffraction grating-optical modulation elements, and dimensions of the members and so forth are merely illustrative and can be altered suitably.

Where the amount of heat generated from the semiconductor chips is small, the via holes for heat transmission for thermally connecting the semiconductor chip and the support member to each other need not be provided.

Although, in the embodiment 2, the support member projection 161 is provided on the support member 160, the surface of the portion of the support member 160 which is exposed in the opening 152 formed in the mounting substrate 150 may be substantially in level with the face 150A of the mounting substrate 150 as seen from the schematic partial sectional view of FIG. 2B. It is to be noted that also the structure just described can be applied to the embodiment 3 or the embodiment 4.

While, in the embodiments described above, the support members 60, 160 and 260 are made of aluminum (Al), they may otherwise be made of copper (Cu), beryllium-copper alloy, silver or gold. Alternatively, they may be made of a material of at least two materials selected from a group consisting of the materials mentioned. In this instance, the support member is preferably formed in a multilayer structure.

While, in the embodiments described above, the top faces of the movable electrodes 32 and the top faces of the fixed electrodes 31 extend in parallel to the top face of the lower electrode 22, the movable electrodes 32 and the fixed electrodes 31 may be formed as electrodes of the blazed type inclined by a blaze angle $\theta_D$ with respect to the top face of the lower electrode 22 so that, for example, only + first order (m = +1) diffracted light may be emitted.

While preferred embodiments of the present invention have been described using specific terms, such description is for illustrative purposes only, and it is to be understood that changes and variations may be made without departing from the scope of the following claims.

**Claims**

**1.** An optical apparatus, comprising:

an optical element (11);

a mounting substrate (50);
a support member (60); and
a cooling/heat radiating member (70);
said support member (60) being attached to a first face (50A) of said mounting substrate (50);
said optical element (11) being attached to a second face (50B) of said mounting substrate (50);
said cooling/heat radiating member (70) being attached to said support member (60);
said optical element (11) and said support member (60) being thermally connected to each other by a heat transmission element (51) provided in the inside of said mounting substrate (50);
said support member (60) being made of a material having a thermal conductivity of 230 W/m·K or more ;

said optical apparatus being **characterized in that** said optical element (11) is formed from a diffraction grating-optical modulation apparatus (11) including a lower electrode (22), a belt-shaped fixed electrode (31) supported above said lower electrode (22), and a belt-shaped movable electrode (32) supported above said lower electrode (22) in a juxtaposed relationship with said fixed electrode (31), a plurality of diffraction grating-optical modulation elements (21) each of which includes a diffraction grating formed from said movable electrode (32) and said fixed electrode (31) as said movable electrode (32) is displaced toward said lower electrode (22) by electrostatic force generated through application of voltages to said movable electrode (32) and said lower electrode (22) and acting between said movable electrode (32) and said lower electrode (22) being formed on a surface of said support member.

2. The optical apparatus according to claim 1, wherein said heat transmission element is formed from a via hole (51) for heat transmission formed in the inside of said mounting substrate (50).

3. The optical apparatus according to claim 1, further comprising a semiconductor chip (40) including a circuit necessary to drive said optical element (11), said semiconductor chip (40) being attached to the second face (50B) of said mounting substrate (50).

4. An optical apparatus, comprising:

an optical element (11);
a mounting substrate (150) for mounting semiconductor chips (40); and
a support member (160);
said mounting substrate (150) having an opening (152) formed therein;
said support member (160) being attached to one face (150A) of said mounting substrate (150);
said optical element (11) being attached to a portion (161) of said support member (160) which is exposed to said opening (152) formed in said mounting substrate (150);
said support member (160) being made of a material having a thermal conductivity of 230 W/m·K or more

said optical apparatus being **characterized in that** said optical element (11) is formed from a diffraction grating-optical modulation apparatus including a lower electrode (22), a belt-shaped fixed electrode (31) supported above said lower electrode (22), and a belt-shaped movable electrode (32) supported above said lower electrode (22) in a juxtaposed relationship with said fixed electrode (31), a plurality of diffraction grating-optical modulation elements (21) each of which includes a diffraction grating formed from said movable electrode (32) and said fixed electrode (31) as said movable electrode (32) is displaced toward said lower electrode (22) by electrostatic force generated through application of voltages to said movable electrode (32) and said lower electrode (22) and acting between said movable electrode (32) and said lower electrode (22) being formed on a surface of said support member.

5. The optical apparatus according to claim 4, further comprising a semiconductor chip (40) including a circuit necessary to drive said optical element (11), said semiconductor chip (40) being attached to the portion (161) of said support member (160) which is exposed to said opening (152) formed in said mounting substrate (150).

6. An optical apparatus, comprising:

an optical element (11);
a mounting substrate (250) for mounting semiconductor chips (40); and
a support member (260);
said support member (260) being attached to one face (250A) of said mounting substrate (250) in such a manner as to extend from an edge portion (250C) of said mounting substrate (250) to said one face (250A) of said mounting substrate (250);

said optical member (11) being attached to the portion (261) of said support member (260) which extends to the outer side of said mounting substrate (250);

said support member (260) being made of a material having a thermal conductivity of 230 W/m·K or more said optical apparatus being **characterized in that** said optical element (11) is formed from a diffraction grating-optical modulation apparatus including a lower electrode (22), a belt-shaped fixed electrode (31) supported above said lower electrode (22), and a belt-shaped movable electrode (32) supported above said lower electrode (22) in a juxtaposed relationship with said fixed electrode (31), a plurality of diffraction grating-optical modulation elements (21) each of which includes a diffraction grating formed from said movable electrode (32) and said fixed electrode (31) as said movable electrode (32) is displaced toward said lower electrode (22) by electrostatic force generated through application of voltages to said movable electrode (32) and said lower electrode (22) and acting between said movable electrode (32) and said lower electrode (22) being formed on a surface of said support member.

7. The optical apparatus according to any one of claims 4 and 6, further comprising a cooling/heat radiating member (70) attached to said support member (160; 260).

8. The optical apparatus according to any one of claims 1, 4 and 6, wherein said support member (60; 160; 260) is made of aluminum, copper, a beryllium copper alloy, silver or gold.

9. The optical apparatus according to any one of claims 1, 4 and 6, wherein said mounting substrate (50; 150; 250) is formed from a printed circuit board.

10. The optical apparatus according to claim 6, further comprising a semiconductor chip (40) including a circuit necessary to drive said optical element (11), said semiconductor chip (40) being attached to the portion (261) of said support member (260) which extends to the outer side of said mounting substrate (250).

11. An image production apparatus, comprising:

   a light source; and
   an optical apparatus according to claim 1 wherein said optical element (11) is provided for emitting light incoming from said light source.

12. An image production apparatus, comprising:

   a light source; and
   an optical apparatus according to claim 4 wherein said optical element (11) is provided for emitting light incoming from said light source.

13. An image production apparatus, comprising:

   a light source; and
   an optical apparatus according to claim 6 wherein said optical element (11) is provided for emitting light incoming from said light source.

**Patentansprüche**

1. Optische Vorrichtung, welche umfasst:

   ein optisches Element (11);
   ein Montagesubstrat (50);
   ein Trägerelement (60); und
   ein Kühl-/Wärmeabstrahlelement (70);
   wobei das Trägerelement (60) an einer ersten Fläche (50A) des Montagesubstrats (50) befestigt ist;
   wobei das optische Element (11) an einer zweiten Fläche (50B) des Montagesubstrats (50) befestigt ist;
   wobei das Kühl-/Wärmeabstrahlungselement (70) an dem Trägerelement (60) befestigt ist;
   wobei das optische Element (11) und das Trägerelement (60) thermisch mittels eines Wärmeübertragungselements (51) miteinander verbunden sind, welches im Inneren des Montagesubstrats (50) vorgesehen ist;

wobei das Trägerelement (60) aus einem Werkstoff mit einer Wärmeleitfähigkeit von 230 W/mK oder höher gefertigt ist;

wobei die optische Vorrichtung **dadurch gekennzeichnet ist, dass** das optische Element (11) aus einer optischen Modulationsvorrichtung (11) mit einem Beugungsgitter gebildet ist, einschließlich einer unteren Elektrode (22), einer bandförmigen fixierten Elektrode (31), die über der unteren Elektrode (22) gelagert ist, und einer bandförmigen beweglichen Elektrode (32), die über der unteren Elektrode (22), und nebengeordnet zu der fixierten Elektrode (31) gelagert, einer Vielzahl von optischen Modulationselementen (21) mit einem Beugungsgitter, von welchen jedes ein Beugungsgitter umfasst, welches aus der beweglichen Elektrode (32) und der fixierten Elektrode (31) gebildet ist, wobei die bewegliche Elektrode (32) in Richtung zu der unteren Elektrode (22) durch eine elektrostatische Kraft verschoben wird, welche durch das Anlegen von Spannungen an die bewegliche Elektrode (32) und die untere Elektrode (22) erzeugt wird und zwischen der beweglichen Elektrode (32) und der unteren Elektrode (22) wirkt, die auf einer Oberfläche des Trägerelements ausgebildet ist.

2. Optische Vorrichtung gemäß Anspruch 1, wobei das Wärmeübertragungselement aus einem Durchgangsloch (51) zur Wärmeübertragung gebildet ist, das im Inneren des Montagesubstrats (50) ausgebildet ist.

3. Optische Vorrichtung gemäß Anspruch 1, welche weiter einen Halbleiterchip (40) mit einer Schaltung umfasst, welche zum Ansteuern des optischen Elements (11) benötigt wird, wobei der Halbleiterchip (40) an der zweiten Fläche (50B) des Montagesubstrats (50) befestigt ist.

4. Optische Vorrichtung, welche umfasst:

ein optisches Element (11);
ein Montagesubstrat (150) zur Montage von Halbleiterchips (40); und
ein Trägerelement (160);
wobei das Montagesubstrat (150) eine darin ausgebildete Öffnung (152) aufweist;
wobei das Trägerelement (160) an einer Fläche (150A) des Montagesubstrats (150) befestigt ist;
wobei das optische Element (11) an einem Abschnitt (161) des Trägerelements (160) befestigt ist, welcher zu der Öffnung (152) exponiert ist, welche in dem Montagesubstrat (150) ausgebildet ist;
wobei das Trägerelement (160) aus einem Werkstoff mit einer Wärmeleitfähigkeit von 230 W/mK oder höher gefertigt ist;

wobei die optische Vorrichtung **dadurch gekennzeichnet ist, dass** das optische Element (11) aus einer optischen Modulationsvorrichtung mit einem Beugungsgitter gebildet ist, einschließlich einer unteren Elektrode (22), einer bandförmigen fixierten Elektrode (31), die über der unteren Elektrode (22) gelagert ist, und einer bandförmigen beweglichen Elektrode (32), die über der unteren Elektrode (22), und nebengeordnet zu der fixierten Elektrode (31) gelagert ist, einer Vielzahl von optischen Modulationselementen (21) mit einem Beugungsgitter, von welchen jedes ein Beugungsgitter umfasst, welches aus der beweglichen Elektrode (32) und der fixierten Elektrode (31) gebildet ist, wobei die bewegliche Elektrode (32) in Richtung zu der unteren Elektrode (22) durch eine elektrostatische Kraft verschoben wird, welche durch das Anlegen von Spannungen an die bewegliche Elektrode (32) und die untere Elektrode (22) erzeugt wird und zwischen der beweglichen Elektrode (32) und der unteren Elektrode (22) wirkt, die auf einer Oberfläche des Trägerelements ausgebildet ist.

5. Optische Vorrichtung gemäß Anspruch 4, welche weiter einen Halbleiterchip (40) mit einer Schaltung umfasst, welche zum Ansteuern des optischen Elements (11) benötigt wird, wobei der Halbleiterchip (40) an einem Abschnitt (161) des Trägerelements (160) befestigt ist, welcher zu der Öffnung (152) exponiert ist, welche in dem Montagesubstrat (150) ausgebildet ist.

6. Optische Vorrichtung, welche umfasst:

ein optisches Element (11);
ein Montagesubstrat (250) zur Montage von Halbleiterchips (40); und
ein Trägerelement (260);
wobei das Trägerelement (260) an einer Fläche (250A) des Montagesubstrats (250) befestigt ist, und zwar derart, dass es sich von einem Randabschnitt (250C) des Montagesubstrats (250) aus bis zu einer Fläche (250A) des Montagesubstrats (250) erstreckt ;
wobei das optische Element (11) an einem Abschnitt (261) des Trägerelements (260) befestigt ist, welcher sich bis zur Außenseite des Montagesubstrats (250) erstreckt ;

wobei das Trägerelement (260) aus einem Werkstoff mit einer Wärmeleitfähigkeit von 230 W/mK oder höher gefertigt ist ;

wobei die optische Vorrichtung **dadurch gekennzeichnet ist, dass** das optische Element (11) aus einer optischen Modulationsvorrichtung mit einem Beugungsgitter gebildet ist, einschließlich einer unteren Elektrode (22), einer bandförmigen fixierten Elektrode (31), die über der unteren Elektrode (22) gelagert ist, und einer bandförmigen beweglichen Elektrode (32), die über der unteren Elektrode (22), und nebengeordnet zu der fixierten Elektrode (31) gelagert ist, einer Vielzahl von optischen Modulationselementen (21) mit einem Beugungsgitter, von welchen jedes ein Beugungsgitter umfasst, welches aus der beweglichen Elektrode (32) und der fixierten Elektrode (31) gebildet ist, wobei die bewegliche Elektrode (32) in Richtung zu der unteren Elektrode (22) durch eine elektrostatische Kraft verschoben wird, welche durch das Anlegen von Spannungen an die bewegliche Elektrode (32) und die untere Elektrode (22) erzeugt wird und zwischen der beweglichen Elektrode (32) und der unteren Elektrode (22) wirkt, die auf einer Oberfläche des Trägerelements ausgebildet ist.

**7.** Optische Vorrichtung gemäß einem der Ansprüche 4 und 6, welche weiter ein KÜhl-/Wärmeabstrahlelement (70) umfasst, welches an dem Trägerelement (160; 260) befestigt ist.

**8.** Optische Vorrichtung gemäß einem der Ansprüche 1, 4 und 6, wobei das Trägerelement (60; 160; 260) aus Aluminium, Kupfer, einer Beryllium-KupferLegierung, Silber oder Gold gefertigt ist.

**9.** Optische Vorrichtung gemäß einem der Ansprüche 1, 4 und 6, wobei das Montagesubstrat (50; 150; 250) aus einer gedruckten Leiterplatte gebildet ist.

**10.** Optische Vorrichtung gemäß Anspruch 6, welche weiter einen Halbleiterchip (40) mit einer Schaltung umfasst, welche zum Ansteuern des optischen Elements (11) benötigt wird, wobei der Halbleiterchip (40) an einem Abschnitt (261) des Trägerelements (260) befestigt ist, welcher sich bis zur Außenseite des Montagesubstrats (250) erstreckt.

**11.** Bilderzeugungsvorrichtung, welche umfasst,

eine Lichtquelle: und

eine optische Vorrichtung gemäß Anspruch 1, wobei das optische Element (11) zum Emittieren von Licht vorgesehen ist, welches von der Lichtquelle kommt.

**12.** Bilderzeugungsvorrichtung, welche umfasst:

eine Lichtquelle; und

eine optische Vorrichtung gemäß Anspruch 4, wobei das optische Element (11) zum Emittieren von Licht vorgesehen ist, welches von der Lichtquelle kommt.

**13.** Bilderzeugungsvorrichtung, welche umfasst:

eine Lichtquelle; und

eine optische Vorrichtung gemäß Anspruch 6, wobei das optische Element (11) zum Emittieren von Licht vorgesehen ist, welches von der Lichtquelle kommt.

**Revendications**

**1.** Appareil optique comprenant :

un élément optique (11) ;

un substrat de montage (50);

un élément de support (60); et

un élément de refroidissement/de rayonnement thermique (70) ;

ledit élément de support (60) étant attaché à une première face (50A) dudit substrat de montage (50);

ledit élément optique (11) étant attaché à une seconde face (50B) dudit substrat de montage (50) ;

ledit élément de refroidissement/de rayonnement thermique (70) étant attaché audit élément de support (60),

ledit élément optique (11) et ledit élément de support (60) étant connectés thermiquement l'un à l'autre au moyen d'un élément de transmission de chaleur (51) prévu à l'intérieur dudit substrat de montage (50) ; ledit élément de support (60) étant fabriqué à partir d'un matériau d'une conductivité thermique de 230 W/m•K ou plus ;

ledit appareil optique étant **caractérisé en ce que** ledit élément optique (11) est formé à partir d'un appareil de modulation optique par réseau de diffraction (11) comprenant une électrode inférieure (22), une électrode fixe en forme de courroie (31) supportée au-dessus de ladite électrode inférieure (22), et une électrode mobile en forme de courroie (32) supportée au-dessus de ladite électrode inférieure (22) dans une relation de juxtaposition avec ladite électrode fixe (31), une pluralité d'éléments de modulation optique par réseau de diffraction (21) comprenant chacun un réseau de diffraction formé à partir de l'électrode mobile (32) et ladite électrode fixe (31) pendant que ladite électrode mobile (32) est déplacée vers ladite électrode inférieure (22) par une force électrostatique générée par l'intermédiaire d'une application de tensions à ladite électrode mobile (32) et ladite électrode inférieure (22) et agissant entre ladite électrode mobile (32) et ladite électrode inférieure (22) formées sur une surface dudit élément de support.

2. Appareil optique selon la revendication 1, dans lequel ledit élément de transmission de chaleur est formé à partir d'un trou d'interconnexion (51) pour une transmission de chaleur formé à l'intérieur dudit substrat de montage (50).

3. Appareil optique selon la revendication 1, comprenant en outre une puce à semi-conducteur (40) comprenant un circuit nécessaire à l'excitation dudit élément optique (11), ladite puce à semi-conducteur (40) étant attachée à la seconde face (50B) dudit substrat de montage (50).

4. Appareil optique comprenant :

un élément optique (11) ;
un substrat de montage (150) destiné à monter des puces à semi-conducteurs (40) ; et
un élément de support (160) ; et
ledit substrat de montage (150) ayant une ouverture (152) formée dans celui-ci ;
ledit élément de support (160) étant attaché à une face (150A) dudit substrat de montage (150) ;
ledit élément optique (11) étant attaché à une portion (161) dudit élément de support (160) qui est exposé à ladite ouverture (152) formée dans ledit substrat de montage (150) ;
ledit élément de support (160) étant fabriqué à partir d'un matériau d'une conductivité thermique de 230 W/m•K ou plus.
ledit appareil optique étant **caractérisé en ce que** ledit élément optique (11) est formé à partir d'un appareil de modulation optique par réseau de diffraction comprenant une électrode inférieure (22), une électrode fixe en forme de courroie (31) supportée au-dessus de ladite électrode inférieure (22), et une électrode mobile en forme de courroie (32) supportée au-dessus de ladite électrode inférieure (22) dans une relation de juxtaposition avec ladite électrode fixe (31), une pluralité d'éléments de modulation optique par réseau de diffraction (21) comprenant chacun un réseau de diffraction formé à partir de l'électrode mobile (32) et ladite électrode fixe (31) pendant que ladite électrode mobile (32) est déplacée vers ladite électrode inférieure (22) par une force électrostatique générée par l'intermédiaire d'une application de tensions à ladite électrode mobile (32) et ladite électrode inférieure (22) et agissant entre ladite électrode mobile (32) et ladite électrode inférieure (22) formées sur une surface dudit élément de support.

5. Appareil optique selon la revendication 4, comprenant en outre une puce à semi-conducteur (40) comprenant un circuit nécessaire à l'excitation dudit élément optique (11), ladite puce à semi-conducteur (40) étant attachée à la portion (161) dudit élément de support (160) qui est exposé à ladite ouverture (152) formée dans ledit substrat de montage (150).

6. Appareil optique comprenant:

un élément optique (11);
un substrat de montage (250) destiné à monter des puces à semi-conducteurs (40) ; et
un élément de support (260);
ledit élément de support (260) étant attaché à une face (250A) dudit substrat de montage (250) de manière à s'étendre depuis une portion de bord (250C) dudit substrat de montage (250) jusqu'à l'une dite face (250A) dudit substrat de montage (250) ;
ledit élément optique (11) étant attaché à la portion (261) dudit élément de support (260) qui s'étend jusqu'au côté externe dudit substrat de montage (250) ;

ledit élément de support (260) étant fabriqué à partir d'un matériau d'une conductivité thermique de 230 W/m•K ou plus.

Ledit appareil optique étant **caractérisé en ce que** ledit élément optique (11) est formé à partir d'un appareil de modulation optique par réseau de diffraction comprenant une électrode inférieure (22), une électrode fixe en forme de courroie (31) supportée au-dessus de ladite électrode inférieure (22), et une électrode mobile en forme de courroie (32) supportée au-dessus de ladite électrode inférieure (22) dans une relation de juxtaposition avec ladite électrode fixe (31), une pluralité d'éléments de modulation optique par réseau de diffraction (21) comprenant chacun un réseau de diffraction formé à partir de ladite électrode mobile (32) et ladite électrode fixe (31) pendant que ladite électrode mobile (32) est déplacée vers ladite électrode inférieure (22) par une force électrostatique générée par l'intermédiaire d'une application de tensions à ladite électrode mobile (32) et ladite électrode inférieure (22) et agissant entre ladite électrode mobile (32) et ladite électrode inférieure (22) formées sur une surface dudit élément de support .

7.  Appareil optique selon l'une quelconque des revendications 4 et 6, comprenant en outre un élément de refroidissement/de rayonnement thermique (70) attaché audit élément de support (160 ; 260).

8.  Appareil optique selon l'une quelconque des revendications 1, 4 et 6, dans lequel ledit élément de support (60 ; 160 ; 260) est en aluminium, cuivre, alliage béryllium-cuivre, argent ou or.

9.  Appareil optique selon l'une quelconque des revendications 1, 4 et 6, dans lequel ledit substrat de montage (50 ; 150 ; 250) est formé à partir d'une carte de circuit imprimé.

10. Appareil optique selon la revendication 6, comprenant en outre une puce à semi-conducteur (40) comprenant un circuit nécessaire à l'excitation dudit élément optique (11), ladite puce à semi-conducteur (40) étant attachée à la portion (261) dudit élément de support (260) qui s'étend jusqu'au côté externe dudit substrat de montage (250).

11. Appareil de production d'image comprenant:

    une source de lumière ; et
    un appareil optique selon la revendication 1, dans lequel ledit élément optique (11) est prévu pour émettre une lumière entrante provenant de ladite source de lumière.

12. Appareil de production d'image comprenant:

    une source de lumière ; et
    un appareil optique selon la revendication 4, dans lequel ledit élément optique (11) est prévu pour émettre une lumière entrante provenant de ladite source de lumière.

13. Appareil de production d'image comprenant :

    une source de lumière ; et
    un appareil optique selon la revendication 6, dans lequel ledit élément optique (11) est prévu pour émettre une lumière entrante provenant de ladite source de lumière.

# F I G. 1 A

DIFFRACTION GRATING-OPTICAL
MODULATION APPARATUS ASSEMBLY

# F I G. 1 B

DIFFRACTION GRATING-OPTICAL
MODULATION APPARATUS ASSEMBLY

EP 1 542 058 B1

# FIG. 2A

DIFFRACTION GRATING–OPTICAL
MODULATION APPARATUS ASSEMBLY

# FIG. 2B

DIFFRACTION GRATING–OPTICAL
MODULATION APPARATUS ASSEMBLY

25

# F I G. 3 A

DIFFRACTION GRATING-OPTICAL
MODULATION APPARATUS ASSEMBLY

# F I G. 3 B

# F I G. 4

# F I G. 5 A

152

151

150

# F I G. 5 B

161 152

151

150

160

# F I G. 6 A

# F I G. 6 B

# F I G. 7 A

40　　　40

150

152

11

40　　　40

# F I G. 7 B

40　　　40

150

152

11

150C

40　　　40

# F I G. 8

# F I G. 9 A

X DIRECTION

# F I G. 9 B

X DIRECTION

# F I G. 1 0 A

25    26

32

22    12

$\longrightarrow$ X DIRECTION

# F I G. 1 0 B

21    21

$\triangle h_0$    32    31    $\rightarrow$$\mid$$\leftarrow$ SP    $\triangle h_1$    32    31

$\mid\leftarrow$ d $\rightarrow\mid$

$W_M$

$W_F$    $\longrightarrow$ Y DIRECTION

22    12

# F I G. 1 1

# F I G. 1 2

EP 1 542 058 B1

# F I G. 1 3

DIFFRACTION GRATING-OPTICAL
MODULATION APPARATUS ASSEMBLY